# EUROPEAN PATENT APPLICATION

(11) **EP 4 333 582 A1**
(43) Date of publication of application: **06.03.2024**
(21) Application number: 22855269.1
(22) Date of filing: 01.08.2022
(51) Int. Cl.: H05K 7/20, F24F 1/24

(54) **HEAT DISSIPATION PLATE, HEAT DISSIPATION PLATE ASSEMBLY, HEAT DISSIPATION ASSEMBLY, ELECTRIC CONTROL BOX, AND AIR CONDITIONER**

(30) Priority: 07.08.2021 CN 202110904561; 07.08.2021 CN 202121838399 U; 07.08.2021 CN 202121838501 U; 07.08.2021 CN 202121838628 U
(71) Applicant: GD Midea Heating & Ventilating Equipment Co., Ltd., Foshan, Guangdong 528311 (CN); HEFEI MIDEA HEATING & VENTILATING EQUIPMENT CO., LTD., Boyan Science Park, High-Tech Zone, Hefei Anhui 230088 (CN)
(72) Inventor: LUO, Huadong, Foshan, Guangdong 528311 (CN); WANG, Guochun, Foshan, Guangdong 528311 (CN); WANG, Mingren, Foshan, Guangdong 528311 (CN); HUANG, Langshui, Foshan, Guangdong 528311 (CN); XU, An, Foshan, Guangdong 528311 (CN); SONG, Kaiquan, Foshan, Guangdong 528311 (CN)
(74) Representative: Whitlock, Holly Elizabeth Ann
(86) International application number: PCT/CN2022/109379
(87) International publication number: WO 2023/016286

(57) **Abstract**

A heat dissipation plate (100) of an electric control box (100), a heat dissipation plate assembly (130), a heat dissipation assembly (120), the electric control box (100), and an air conditioner, relating to the technical field of air conditioning devices. The heat dissipation plate (100) of the electric control box (100) comprises a heat dissipation plate body (110), at least two heat dissipation bosses (120) are provided on the heat dissipation plate body (110) at intervals, an accommodating area (170) is formed between at least two adjacent heat dissipation bosses (120), and a temperature and humidity sensor (160) is provided in the accommodating area (170). The heat dissipation assembly (120) comprises a heat exchange member (200) and the heat dissipation plate (100), and the heat exchange member (200) is located on the side of the heat dissipation plate (100) away from the heat dissipation boss (120). The electric control box (100) comprises a mounting plate (400) and the heat dissipation assembly (120), and the mounting plate (400) and the heat dissipation plate (100) of the heat dissipation assembly (120) are stacked. The air conditioner comprises a main body device and the electric control box (100). The electric control box (100) is mounted on the main body device.

## Description

This application claims priority to the Chinese Patent Application No. 202110904561.4 filed on August 7, 2021 with the China National Intellectual Property Administration and entitled with "HEAT DISSIPATION PLATE FOR ELECTRIC CONTROL BOX, HEAT DISSIPATION COMPONENT, ELECTRIC CONTROL BOX, AND AIR CONDITIONER"; the Chinese Patent Application No. 202121838399.2 filed on August 7, 2021 with the China National Intellectual Property Administration and entitled with "HEAT DISSIPATION PLATE COMPONENT, ELECTRIC CONTROL BOX, OUTDOOR AIR CONDITIONING UNIT, AND AIR CONDITIONER"; the Chinese Patent Application No. 202121838501.9 filed on August 7, 2021 with the China National Intellectual Property Administration and entitled with "HEAT DISSIPATION COMPONENT, ELECTRIC CONTROL BOX, AND AIR CONDITIONER"; and the Chinese Patent Application No. 202121838628.0 filed on August 7, 2021 with the China National Intellectual Property Administration and entitled with "ELECTRIC CONTROL BOX AND AIR CONDITIONER". All of the aforementioned applications are hereby incorporated by reference in their entireties.

### TECHNICAL FIELD

The present disclosure relates to the field of air conditioning equipment technologies and, in particular, to a heat dissipation plate, a heat dissipation plate component, a heat dissipation component, an electric control box, and an air conditioner.

### BACKGROUND

A central air conditioner is composed of one or more cold and heat source systems and multiple air conditioning systems. Unlike a traditional refrigerant-type air conditioner, the central air conditioner can centrally handle air to achieve a requirement of comfort. The external unit of the central air conditioner is provided with an electric control box that controls the central air conditioning. The electric control box is internally provided with a heat dissipation plate, which is used to dissipate heat for the electrical component inside the electric control box. However, condensate water can easily form on the heat dissipation plate in related technologies, which can cause damage to the electrical component inside the electric control box.

### SUMMARY

At least one embodiment of the present disclosure provides a heat dissipation plate for an electric control box, which includes a heat dissipation plate body, where the heat dissipation plate body is provided with at least two heat dissipation boss plates that are arranged to be spaced apart; wherein an accommodation area is formed between at least two adjacently arranged heat dissipation boss plates, and the accommodation area is provided with a temperature-and-humidity sensor.

On the basis of the heat dissipation plate for the electric control box provided in the present disclosure, the following improvements can be made in the present disclosure.

Furthermore, the heat dissipation boss plate has a drainage surface configured to discharge water that flows to the drainage surface out of the heat dissipation boss plate.

Furthermore, in the accommodation area, the temperature-and-humidity sensor is arranged away from drainage surfaces of the two adjacent heat dissipation boss plates.

Furthermore, in the accommodation area, the temperature-and-humidity sensor is arranged close to the drainage surface of any one of the two adjacent heat dissipation boss plates.

Furthermore, a drainage groove is formed in the accommodation area, and the drainage surfaces of the two adjacent heat dissipation boss plates are connected to a first end of the drainage groove, a second end of the drainage groove extends in a direction away from an extension direction of the drainage surfaces; and the drainage groove is configured to discharge water on the drainage surfaces from the heat dissipation boss plates.

Furthermore, the accommodation area is provided with a block, which forms the drainage groove with an adjacent heat dissipation boss plate.

Furthermore, the temperature-and-humidity sensor is arranged in the drainage groove and is arranged close to the second end of the drainage groove.

Furthermore, the heat dissipation plate body is provided with at least one limit boss plate; both the limit boss plate and the heat dissipation plate body are arranged on the same plate surface of the heat dissipation plate body; and the limit boss plate is arranged between the heat dissipation plate body and the heat dissipation boss plate.

Furthermore, there are multiple limit boss plates, which are arranged to be spaced apart on the heat dissipation plate body.

Furthermore, at least one of the multiple limit boss plates is provided with the at least two heat dissipation boss plates; the at least two heat dissipation boss plates are arranged to be spaced apart on the same limit boss plate; and the accommodation area is formed between two adjacently arranged heat dissipation boss plates on the same limit boss plate.

Furthermore, a detection end of the temperature-and-humidity sensor is no higher than a surface of the heat dissipation boss plate facing away from the heat dissipation plate body.

The present disclosure further provides a heat dissipation component, which includes a heat exchanger and the heat dissipation plate for the electric control box described in any one of the above technical solutions, wherein the heat exchanger is arranged on a side of the heat dissipation plate away from the heat dissipation boss plate.

Furthermore, the heat exchanger is adhered to a surface of the heat dissipation plate for the electric control box away from the side of the heat dissipation boss plate; and a projection of the heat exchanger on the heat dissipation plate for the electric control box coincides at least partially with the temperature-and-humidity sensor of the heat dissipation plate for the electric control box.

The present disclosure further provides an electric control box, which includes an installation plate and the heat dissipation component described in any one of the above technical solutions, where the installation plate and the heat dissipation plate of the heat dissipation component are arranged in layers.

Furthermore, the electric control box is a sealed electric control box.

The present disclosure further provides an air conditioner, which includes a main device and the electric control box described in any one of the above technical solutions, where the electric control box is mounted on the main device.

At least one embodiment of the present disclosure provides a heat dissipation plate component, which includes a heat dissipation plate, wherein the heat dissipation plate is provide with a connection hole. The heat dissipation plate component of the present application further includes a connector, wherein the connector is embedded in the connection hole. In order to facilitate to embed the connector in the connection hole, a hardness of the connector should be greater than a hardness of the heat dissipation plate; the connector has a threaded installation hole, an axial direction of the threaded installation hole is consistent with an axial direction of the connection hole; and the connector is configured to be connected to a retaining plate through the threaded installation hole.

On the basis of the heat dissipation plate component provided in the present disclosure, the following improvements can be made.

Furthermore, the connector is press-fitted to the connection hole.

Furthermore, the connector has a first end face and a second end face that are arranged to be spaced apart along its axis, and the first end face is arranged opposite to the second end face, where the first end face is flush with a plate surface of the heat dissipation plate, and the second end face is arranged in the connection hole.

Furthermore, the first end face has a maximum radial length in a radial direction of the threaded installation hole, the second end face has a maximum radial length in the radial direction of the threaded installation hole, and the maximum radial length of the first end face in the radial direction of the threaded installation hole is greater than the maximum radial length of the second end face.

Furthermore, the connector includes multiple anti-rotation units, which are sequentially connected along the axial direction of the threaded installation hole, projection surfaces of the anti-rotation units in the axial direction of the connection hole are non-circular surfaces, and maximum radial lengths of the multiple anti-rotation units in the radial direction of the threaded installation hole gradually decrease in a direction from an end face of the connection hole to a bottom of the connection hole.

Furthermore, the anti-rotation units include multiple anti-rotation parts distributed in a circumferential direction of the connector; and outer circumferential edges of an anti-rotation part are non-circular edges.

Furthermore, outer circumferential edge surfaces of the anti-rotation parts are flat surfaces, so that the projection surfaces of the anti-rotation units in the axial direction of the connection hole are polygonal. Furthermore, maximum radial edges of the projection surfaces of the anti-rotation units in the axial direction of the connection hole are each arranged on the same circumference, and the maximum radial edges of the projection surfaces of the individual anti-rotation units in the axial direction of the connection hole are arranged on circumferences that are equal.

Furthermore, the anti-rotation part has a guide surface facing a bottom end of the connection hole, which is arranged to be inclined relative to an axial direction of the connector, and an outer side of the guide surface is higher than an inner side of the guide surface.

Furthermore, the anti-rotation part further includes a stop surface, which is arranged on a side of the guide surface facing away from the bottom of the connection hole, and an extension direction of the stop surface is consistent with a radial direction of the connection hole. By providing the stop surface on the anti-rotation part, positions of the connector and the heat dissipation plate in the axial direction of the connection hole can be limited.

Furthermore, the stop surface is parallel to the first end face.

Furthermore, the connector further includes a first support portion and a second support portion, where the first support portion is arranged opposite to the second support portion, and multiple anti-rotation units are connected between the first support portion and the second support portion; the first end face is arranged at an end of the first support portion facing away from the second support portion, and the second end face is arranged at an end of the second support portion facing away from the first support portion.

Furthermore, an outer contour of a projection surface of the first end face in the axial direction of the connection hole is circular, while an outer contour of a projection surface of the second end face in the axial direction of the connection hole is polygonal.

Furthermore, the connector further includes multiple connection parts, which are arranged to correspond to the anti-rotation units one by one; the connection parts are connected between the first support portion and the anti-rotation units; and/or, the connection parts are connected between two adjacent anti-rotation units.

At least one embodiment of the present disclosure further provides an electric control box, which includes a box body and the heat dissipation plate component of any one of the above technical solutions, where the heat dissipation plate component is arranged inside the box body.

Furthermore, the heat dissipation plate component includes a heat dissipation plate and a microchannel heat exchanger, the microchannel heat exchanger is arranged at a bottom of the box body, and the heat dissipation plate is arranged on a side of the microchannel heat exchanger facing away from the bottom of the box body.

Furthermore, the electric control box further includes a retaining plate, which is arranged inside the box body, and the retaining plate is arranged on a side of the heat dissipation plate facing away from the bottom of the box body.

Furthermore, the box body includes a box cover and a box main body with an opening, the box cover covers the opening of the box main body, the heat dissipation plate component is provided at a bottom of the box main body, the retaining plate is arranged on a side of the heat dissipation plate component facing the opening, and the retaining plate is connected to the connector of the heat dissipation plate component.

Furthermore, the electric control box is a sealed electric control box.

The present disclosure further provides an outdoor air conditioning unit, which includes the above electric control box.

The present disclosure further provides an air conditioner, which includes the above outdoor air conditioning unit.

At least one embodiment of the present disclosure provides a heat dissipation component, which includes a heat dissipation plate and a heat exchange tube component; the heat dissipation plate and the heat exchange tube component are arranged in layers; a surface of the heat dissipation plate facing the heat exchange tube component is in contact with a surface of the heat exchange tube component facing the heat dissipation plate; the surface of the heat dissipation plate facing the heat exchange tube component is provided with a limit rib, the limit rib extends along an extension direction of the heat exchange tube component; a side surface of the limit rib facing the heat exchange tube component abuts against a side surface of heat exchange tube component facing the limit rib; and the heat dissipation plate and limit rib are an integrated part.

On the basis of the heat dissipation component provided in the present disclosure, the following improvements may be made.

Furthermore, the heat dissipation plate and the limit rib are an integrated part formed through an extrusion molding process.

Furthermore, a top of the limit rib is lower than a surface of the heat exchange tube component away from the heat dissipation plate, or the top of the limit rib is flush with the surface of the heat exchange tube component away from the heat dissipation plate.

Furthermore, the heat exchange tube component includes one or more heat exchange tubes, and the limit rib is at least two, the at least two limit ribs are arranged to be spaced apart; and at least one heat exchange tube is clamped between two adjacent limit ribs.

Furthermore, the heat exchange tube component includes at least two heat exchange tubes, which are parallel to each other and arranged to be spaced apart in a plane parallel to the heat dissipation plate.

Furthermore, a surface of the heat dissipation plate facing the heat exchange tube is provided with a groove, the groove extends along an extension direction of the heat exchange tube, and the groove is arranged between two adjacent heat exchange tubes.

Furthermore, a width of the groove is less than or equal to a width of a spacing between two adjacent heat exchange tubes.

Furthermore, a depth of the groove is less than or equal to 1/2 of a thickness of the heat dissipation plate.

Furthermore, the heat exchange tube is a microchannel flat tube, and a flat surface of the microchannel flat tube is in contact with the heat dissipation plate.

Furthermore, a surface of the heat dissipation plate facing the heat exchange tube is in a welding connection to a surface of the heat exchange tube facing the heat dissipation plate.

Furthermore, a first end of the heat exchange tube is communicated to a refrigerant inlet pipeline, and a second end thereof is communicated to a refrigerant outlet pipeline.

At least one embodiment of the present disclosure further provides an electric control box, which includes a box body and the heat dissipation component as described in any one of the above technical solutions, where the heat dissipation component is arranged inside the box body.

Furthermore, the electric control box is a sealed electric control box, and the heat exchange tube component is at least partially arranged inside the electric control box.

At least one embodiment of the present disclosure further provides an air conditioner, which includes a cabinet body and the electric control box as described in any one of the above-mentioned technical solutions, where the electric control box is mounted to the cabinet body.

At least one embodiment of the present disclosure provides an electric control box, which includes a heat dissipation plate and an installation plate; the heat dissipation plate and installation plate are arranged in layers; a side of the installation plate facing away from the heat dissipation plate is provided with an element to be heat dissipated; a side of the heat dissipation plate facing the installation plate is provided with a heat dissipation boss plate, and a position on the installation plate corresponding to the heat dissipation boss plate is provided with an avoidance hole; and the heat dissipation boss plate penetrates through the avoidance hole and comes into contact with the element to be heat dissipated.

On the basis of the electric control box provided in the present disclosure, the following improvements can be made in the present disclosure.

Furthermore, the side of the heat dissipation plate facing the installation plate is provided with a limit boss plate, the limit boss plate is inserted into the avoidance hole; an outer circumferential side of the limit boss plate contacts an inner circumferential side of the avoidance hole; and the heat dissipation boss plate is arranged on the limit boss plate.

Furthermore, a drainage structure is provided around the heat dissipation boss plate.

Furthermore, the heat dissipation boss plate has a drainage surface, which is used to discharge water that flows to the drainage surface out of the heat dissipation boss plate.

Furthermore, a middle of the drainage surface protrudes relative to both ends of the drainage surface.

Furthermore, the drainage surface is a curved surface or a V-shaped surface.

Furthermore, the heat dissipation boss plate is an elongated block, and an end face on a short side of the elongated block forms the drainage surface.

Furthermore, both sides of the heat dissipation boss plate are provided with a discharge groove, respectively; and two drainage grooves are configured to discharge water flowing down the drainage surface from an area of the heat dissipation plate corresponding to the avoidance hole.

Furthermore, one of the two opposite groove surfaces of the drainage groove is a side surface on a long side of the elongated block, and the side surface is connected to an end of the drainage surface; and the other of the two opposite groove surfaces of the discharge groove is a side surface of the avoidance hole.

Furthermore, both ends of the discharge groove extend to an edge of the limit boss plate along a water flow direction.

Furthermore, a bottom of the drainage groove is higher than a plane where a bottom end of the limit boss plate is arranged, and the bottom of the drainage groove is lower than a top surface of the heat dissipation boss plate.

Furthermore, the limit boss plate is provided with at least two heat dissipation boss plates; the at least two heat dissipation boss plates are arranged to be spaced apart along a direction perpendicular to an extension direction of the discharge groove; two adjacent heat dissipation boss plates are provided with a block therebetween; and the discharge groove is formed between the block and an adjacent heat dissipation boss plate.

Furthermore, a top surface of the block is lower than a top surface of the lowest one of at least two heat dissipation boss plates, or the top surface of the block is flush with the top surface of the lowest one of at least two heat dissipation boss plates.

Furthermore, a side of the heat dissipation plate facing the installation plate is provided with at least two limit boss plates; the at least two limit boss plates are arranged to be spaced apart along a direction perpendicular to the water flow direction; the installation plate is provided with at least two avoidance holes, and at least two limit boss plates are correspondingly extended into at least two avoidance holes.

Furthermore, an edge of the heat dissipation plate is provided with a positioning notch locating an installation position of the heat dissipation plate.

Furthermore, the electric control box is a sealed electric control box; and both the heat dissipation plate and the installation plate are mounted inside the electric control box.

At least one embodiment of the present disclosure further provides an air conditioner, which includes a cabinet body and the electric control box as described in any one of the technical solutions mentioned above, where the electric control box is mounted on the cabinet body.

### BRIEF DESCRIPTION OF DRAWINGS

The specific implementation modes of the present disclosure are described below with reference to the drawings. The drawings are as following.
FIG. 1 is a structural schematic diagram of a heat dissipation plate for an electric control box provided by at least one embodiment of the present disclosure.
FIG. 2 is an enlarged schematic diagram at position A in FIG. 1.
FIG. 3 is another structural schematic diagram of the heat dissipation plate for the electric control box provided by at least one embodiment of the present disclosure.
FIG. 4 is an enlarged schematic diagram at position B in FIG. 3.
FIG. 5 is yet another structural schematic diagram of the heat dissipation plate for the electric control box provided by at least one embodiment of the present disclosure.
FIG. 6 is an enlarged schematic diagram at position C in FIG. 5.
FIG. 7 is a structural schematic diagram of a heat dissipation component provided by at least one embodiment of the present disclosure.
FIG. 8 is a structural schematic diagram of the electric control box provided by at least one embodiment of the present disclosure.
FIG. 9 is an exploded schematic diagram of the electric control box provided by at least one embodiment of the present disclosure.
FIG. 10 is a schematic diagram of a connection between the heat dissipation component and the installation plate in the electric control box provided by at least one embodiment of the present disclosure.
FIG. 11 is an enlarged schematic diagram at position D in FIG. 10.
FIG. 12 is an exploded schematic diagram of the electric control box provided by at least one embodiment of the present disclosure.
FIG. 13a is a three-dimensional structural schematic diagram of a heat dissipation plate component provided by at least one embodiment of the present disclosure.
FIG. 13b is a planar structural schematic diagram of the heat dissipation plate component provided by at least one embodiment of the present disclosure.
FIG. 13c is an enlarged schematic diagram of a local structure at position A in FIG. 13b.
FIG. 14a is a three-dimensional structural schematic diagram of a connector in the heat dissipation plate component provided by at least one embodiment of the present disclosure.
FIG. 14b is a planar structural schematic diagram of the connector in the heat dissipation plate component provided by at least one embodiment of the present disclosure.
FIG. 15a is a cross-sectional view along direction B-B in FIG. 13b.
FIG. 15b is an enlarged schematic diagram of a local structure at position C in FIG. 15a.
FIG. 16 is a cross-sectional view of the connector in the heat dissipation plate component provided by at least one embodiment of the present disclosure.
FIG. 17 is a partial structural schematic diagram of the connector in the heat dissipation plate component provided by at least one embodiment of the present disclosure.
FIG. 18 is a structural schematic diagram of the electric control box provided by at least one embodiment of the present disclosure.
FIG. 19 is an exploded view of the electric control box provided by at least one embodiment of the present disclosure.
FIG. 20 is a structural schematic diagram of the heat dissipation component provided by at least one embodiment of the present disclosure.
FIG. 21 is an enlarged view at position A in FIG. 20.
FIG. 22 is a structural schematic diagram of a heat dissipation plate provided by at least one embodiment of the present disclosure.
FIG. 23 is a side view of the heat dissipation plate provided by at least one embodiment of the present disclosure.
FIG. 24 is a side view schematic diagram of a relative position of the heat dissipation plate with a heat exchange tube provided by at least one embodiment of the present disclosure.
FIG. 25 is a top view of the heat dissipation plate provided by at least one embodiment of the present disclosure.
FIG. 26 is a structural schematic diagram of the electric control box provided by at least one embodiment of the present disclosure.
FIG. 27 is an exploded diagram of the electric control box provided by at least one embodiment of the present disclosure.
FIG. 28 is a structural schematic diagram of the heat dissipation plate being assembled with an installation plate provided by at least one embodiment of the present disclosure.
FIG. 29 is an enlarged view at position A in FIG. 28.
FIG. 30 is a structural schematic diagram of the heat dissipation plate provided by at least one embodiment of the present disclosure.
FIG. 31 is an enlarged view at position B in FIG. 30.
FIG. 32 is a front view of the heat dissipation plate provided by at least one embodiment of the present disclosure.
FIG. 33 is a top view of the heat dissipation plate provided by at least one embodiment of the present disclosure.
FIG. 34 is an enlarged view at position C in FIG. 33.

### DESCRIPTION OF EMBODIMENTS

In related technologies, an electric control box is provided with a heat dissipation plate and an installation plate. A surface of the installation plate is provided with an electronic element, and the heat dissipation plate is provided at a surface of the installation plate facing away from the electronic element. Heat generated by the electronic element during operation is first transferred to the installation plate, and then transferred to the heat dissipation plate to achieve heat dissipation of the electronic element. However, during the operation of the electronic element inside the electric control box, the generated heat will increase a temperature of air inside the electric control box. When the temperature of the air is higher than a temperature of the heat dissipation plate by a certain value and the air has a certain humidity, water molecules in the air will form condensate water when they are in contact with the heat dissipation plate. After the condensate water coming into contact with the electronic element inside the electric control box, it is easy to cause damage to the electronic element inside the electric control box.

In view of this, in a heat dissipation plate for an electric control box in an embodiment of the present disclosure, a heat dissipation plate body is provided with a heat dissipation boss plate, so that an accommodation area can be formed between two heat dissipation boss plates, and a temperature-and-humidity sensor is provided in the accommodation area. By using the temperature-and-humidity sensor to detect temperature and humidity in an area near the heat dissipation plate, temperature of the heat dissipation plate is controlled to prevent formation of condensate water on the heat dissipation plate and avoid damage to the electronic element inside the electric control box due to a contact with the condensate water.

The following will provide a clear and complete description of the technical solution in the embodiments of the present disclosure in combination with the drawings. Obviously, the described embodiments are only a part of the embodiments of the present disclosure, not all of them. Based on the embodiments in the present disclosure, all other embodiments obtained by ordinary technical personnel in the art without creative work shall fall within the protection scope of the present disclosure.

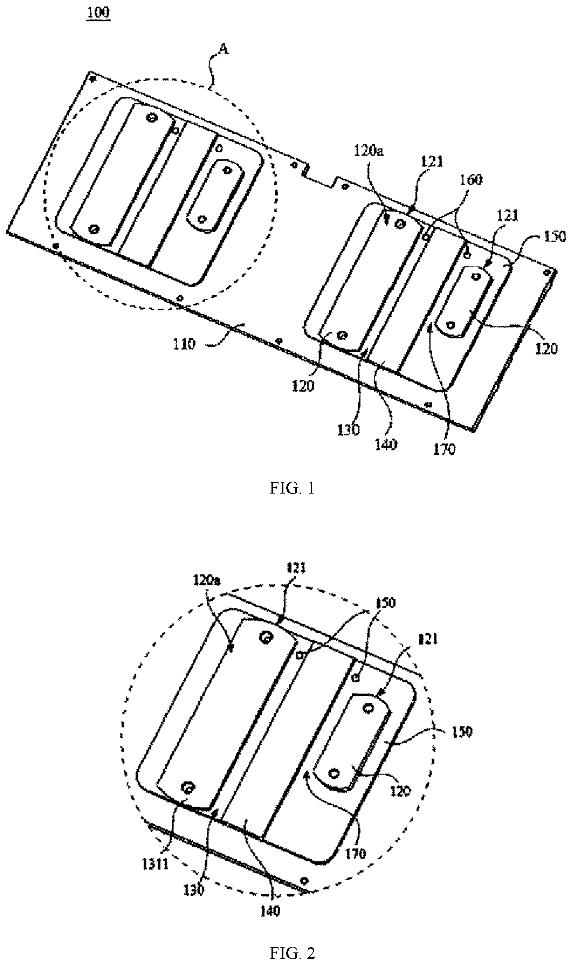

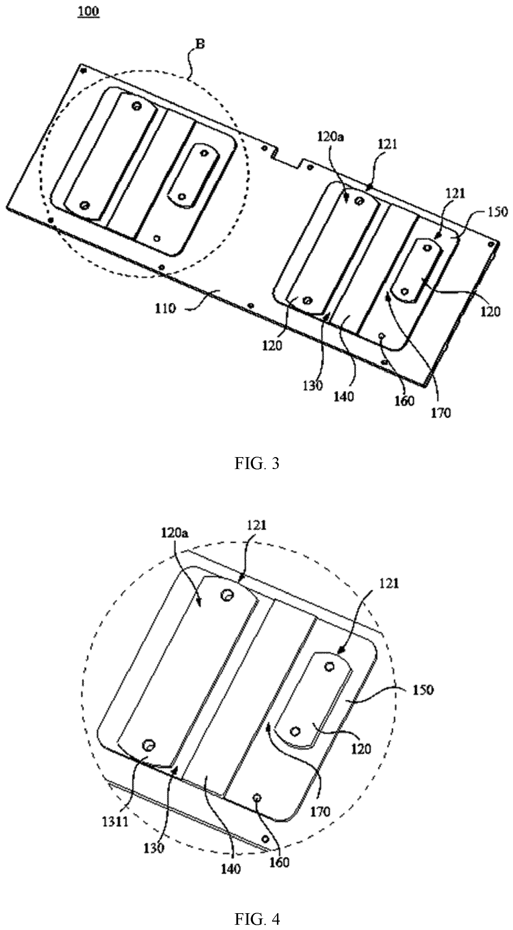

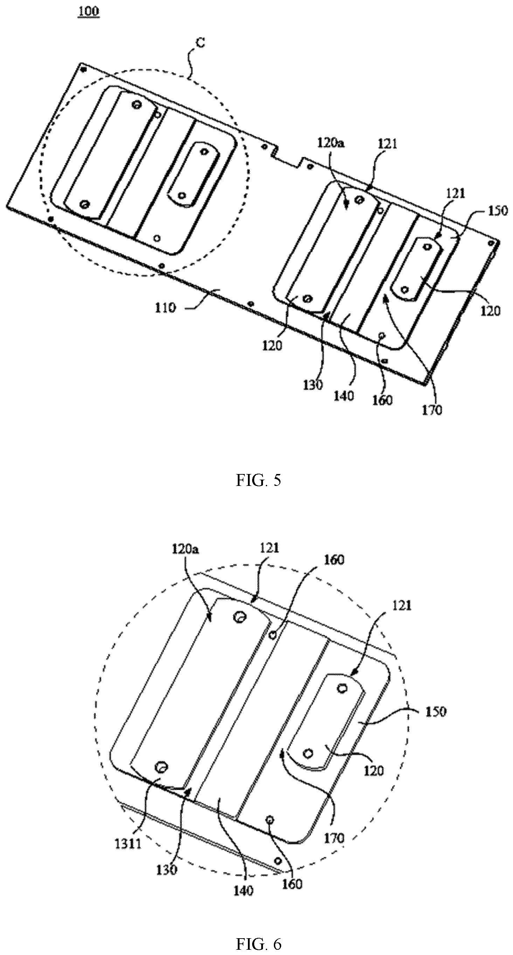

FIG. 1 is a structural schematic diagram of a heat dissipation plate for an electric control box provided by an embodiment of present disclosure; FIG. 2 is an enlarged schematic diagram at position A in FIG. 1; FIG. 3 is another structural schematic diagram of the heat dissipation plate for the electric control box provided by the embodiment of the present disclosure; FIG. 4 is an enlarged schematic diagram at position B in FIG. 3; FIG. 5 is yet another structural schematic diagram of the heat dissipation plate for the electric control box provided by the embodiment of present disclosure; FIG. 6 is an enlarged schematic diagram at position C in FIG. 5.

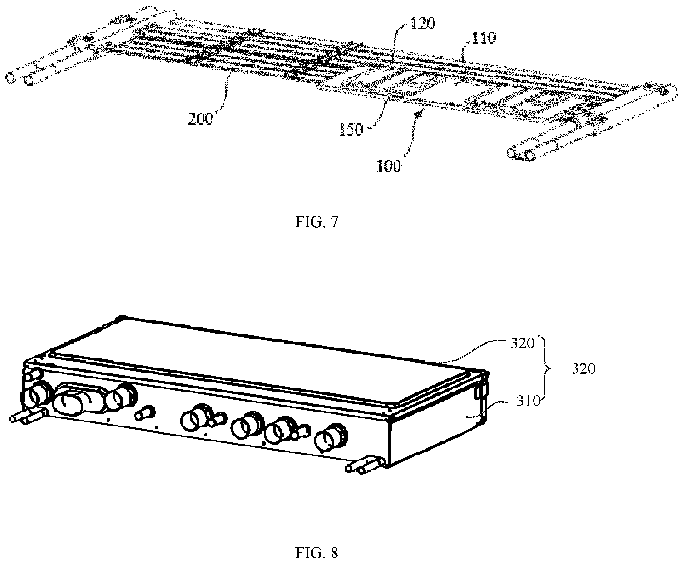

As shown in FIGs. 1 to 6, the embodiments of the present disclosure provide a heat dissipation plate 100 for an electric control box, which includes a heat dissipation plate body 110, the heat dissipation plate body 110 is provided with at least two heat dissipation boss plates 120 that are arranged to be spaced apart. A surface of the heat dissipation plate body 110 facing away from the heat dissipation boss plate 120 is configured to contact a heat exchanger 200 (as shown in FIG. 7) inside the electric control box, so as to transfer heat on the heat dissipation plate 100 to the heat exchanger 200 by means of contact heat exchange, thereby reducing the temperature of the heat dissipation plate 100. The heat dissipation boss plate 120 on the heat dissipation plate 100 is configured to contact an electronic element inside the electric control box. Heat generated by the electronic element inside the electric control box is absorbed by means of contact heat exchange, and a purpose of cooling the electronic element inside the electric control box is achieved.

An accommodation area 170 is formed between two adjacently arranged heat dissipation boss plates 120 on the heat dissipation plate 100, and a temperature-and-humidity sensor 160 is provided within the accommodation area 170. The temperature-and-humidity sensor 160 can detect temperature and humidity in an area near the heat dissipation plate 100. By detecting the obtained temperature and humidity conditions, it can be determined whether air inside the electric control box meets a condition for forming condensate water. Based on this, a heat exchange rate between the heat exchanger 200 and the heat dissipation plate 100 is adjusted, then temperature of the heat dissipation plate 100 is adjusted to allow for a smaller temperature difference between the heat dissipation plate 100 and the air inside the electric control box, thereby avoiding the formation of condensate water after the air inside the electric control box coming into contact with the heat dissipation plate 100.

According to the heat dissipation plate 100 for the electric control box provided in the embodiments of the present disclosure, the temperature and humidity in the area near the heat dissipation plate 100 is detected through the temperature-and-humidity sensor 160 on the heat dissipation plate body 110, so that the detected temperature data and humidity data are used to adjust the heat exchange rate between the heat exchanger 200 and the heat dissipation plate 100, and based on this, the temperature of the heat dissipation plate 100 is indirectly adjusted to reduce the temperature difference between the heat dissipation plate 100 and the air inside the electric control box; the condition for the formation of condensate water cannot be met when the air inside the electrical control box comes into contact with the heat dissipation plate 100; thereby avoiding the formation of condensate water on a surface of the heat dissipation plate 100 and preventing the electronic element inside the electric control box to be damaged.

In addition, the accommodation area 170 is specifically a marginal area between two heat dissipation boss plates 120. Providing the temperature-and-humidity sensor 160 in the accommodation area 170 can save space occupied by the temperature-and-humidity sensor 160 on the heat dissipation plate 100. Moreover, the accommodation area 170 also provides space for placing connection wires of the temperature-and-humidity sensor 160, and the connection wires of the temperature-and-humidity sensor 160 can be arranged within the accommodation area 170, to facilitate the wiring of the temperature-and-humidity sensor 160.

In addition, in order to prevent the temperature-and-humidity sensor 160 from obstructing a contact between the heat dissipation boss plate 120 and the ready-for-heat-dissipation electronic element in the electric control box, a detection end of the temperature-and-humidity sensor 160 in the accommodation area 170 should not be higher than an end face of the heat dissipation boss plate 120 facing away from the heat dissipation plate body 110, where the end face is a heat exchange contact surface 120a between the heat dissipation boss plate 120 and the electronic element to be heat dissipated. That is to say, the highest point of the detection end of the temperature-and-humidity sensor 160 in the accommodation area 170 will not be raised from the heat exchange contact surface 120a of the heat dissipation boss plate 120. In this way, the temperature-and-humidity sensor 160 will not obstruct the contact between the heat dissipation boss plate 120 and the electronic elements to be heat dissipated, so that the heat dissipation boss plate 120 can fully exchange heat with these electronic elements to be heat dissipated, rendering a decrease in the temperature of these electronic elements to be heat dissipated.

Furthermore, since the heat dissipation boss plate 120 and the ready-for-heat-dissipation electronic elements in the electric control box are not obstructed by the temperature-and-humidity sensor 160, a connection between the heat dissipation plate 100 and these electronic elements to be heat dissipated can also be simplified, which facilitates the assembly of the electric control box.

As shown in FIGs. 1 and 2, in order to further avoid a damage to the electronic elements inside the electric control box caused by a contact between condensate water and the electronic elements inside the electric control box, in the embodiments of the present application, the heat dissipation boss plate 120 has a drainage surface 121 which can discharge, from the heat dissipation boss plate 120, the condensate water formed on the drainage surface 121 and the condensate water formed on the heat dissipation boss plate 120 and flowing to the drainage surface 121, thereby preventing the condensate water from coming into contact with the electronic elements.

As shown in FIGs. 1 and 2, the drainage surface 121 is arranged at an edge of the heat dissipation boss plate 120 facing away a surface of the heat dissipation plate body 100. The drainage surface 121 can be an inclined surface or a curved surface, which allows the condensate water, when in contact with the inclined surface or the curved surface, to flow along an extension direction of the drainage surface 121 due to its own gravity; and thus, discharging the condensate water from the heat dissipation boss plate 120.

The drainage surface 121 can surround the edge of the heat dissipation boss plate 120, or be arranged at an edge of a side or edges of several sides of the heat dissipation boss plate 120, and it can be arranged according to an actual scene of the heat dissipation plate 100 during use. Due to the fact that the movement of condensate water is mainly driven by gravity, generally speaking, the drainage surface 121 is arranged in a direction facing gravity, so that it is easier for the condensate water to flow to the drainage surface 121.

Specifically, the drainage surface 121 is an arc chamfer arranged on an outer circumferential edge of the heat exchange contact surface 120a, and two opposite sides at the outer circumferential edge of the heat exchange contact surface 120a are provided with a drainage surface, respectively.

In the embodiments of the present disclosure, a position of the temperature-and-humidity sensor 160 relative to the drainage surface 121 may be arranged in various ways.

As shown in FIGs. 3 and 4, one of them is that the temperature-and-humidity sensor 160 is arranged to be far away from the drainage surfaces 121 of two adjacent heat dissipation boss plates 120. The advantage of arranging the temperature-and-humidity sensor 160 in this way is that it is possible to prevent the condensate water flowing out from the drainage surface 121 from coming into contact with the temperature-and-humidity sensor 160, thereby avoiding an interference to the detection of temperature and humidity near the heat dissipation plate 100 by the temperature-and-humidity sensor 160, and rendering accurate detection results of the temperature-and-humidity sensor 160.

As shown in FIGs. 1 and 2, another way is that the temperature-and-humidity sensor 160 is arranged to be close to the drainage surface 121 of any one of the two adjacent heat dissipation boss plates 120. The advantage of arranging the temperature-and-humidity sensor 160 in this way is that the condensate water flowing out of the drainage surface 121 can come into contact with the temperature-and-humidity sensor 160 in a short period of time, which allows the temperature-and-humidity sensor 160 to detect the formation of condensate water; and issue a warning message outwards to inform a user that there is a high amount of water in the electric control box and there is a risk of damage to the electronic elements inside the electric control box.

Furthermore, as shown in FIGs. 5 and 6, the above-mentioned two arrangement ways of the temperature-and-humidity sensor 160 can also be combined, that is, the temperature-and-humidity sensor 160 is arranged away from the drainage surfaces 121 of the two adjacent heat dissipation boss plates 120 and close to the drainage surface 121 of any one of the two adjacent heat dissipation boss plates 120, respectively. The temperature-and-humidity sensor 160 far away from the drainage surface 121 of the heat dissipation boss plate 120 is used to detect the temperature and humidity near the heat dissipation plate 100, and the temperature-and-humidity sensor 160 close to the drainage surface 121 of the heat dissipation boss plate 120 is used to alert the formation of condensate water. Therefore, based on signals of the temperature-and-humidity sensor 160 arranged in two kinds of positions, a risk level that the electronic element is damaged by the condensate water formed on the heat dissipation plate 100 can be determined.

For example, the temperature-and-humidity sensor 160 close to the drainage surface 121 of the heat dissipation boss plate 120 detects that condensate water has formed, but the temperature-and-humidity sensor 160 far away from the drainage surface 121 of the heat dissipation boss plate 120 detects that the temperature and humidity near the heat dissipation plate 100 are insufficient to form a harmful amount of condensate water for the electronic element inside the electric control box, the formed condensate water can be quickly discharged, and then there is no need to issue a warning message outwards.

For example, the temperature-and-humidity sensor 160 close to the drainage surface 121 of the heat dissipation boss plate 120 detects that condensate water has not been formed, but the temperature-and-humidity sensor 160 far away from the drainage surface 121 of the heat dissipation boss plate 120 detects that the temperature and humidity near the heat dissipation plate 100 are sufficient to form a harmful amount of condensate water for the electronic element inside the electric control box, and condensate water is about to be rapidly formed on the heat dissipation plate 100, then a warning message will be issued outwards to inform the user that a high amount of condensate water is about to form in the electric control box and there is a risk of damage to the electronic element inside the electric control box.

As shown in FIGs. 1 and 2, in the embodiments of present disclosure, in order to discharge, from the heat dissipation boss plate 120, the condensate water flowing to the drainage surface 121 and the condensate water formed on the drainage surface 121, a drainage groove 130 is formed in the accommodation area 170. The drainage surfaces 121 of two adjacent heat dissipation boss plates 120 are both connected to the drainage groove 130; the drainage groove 130 extends in a direction away from the drainage surface 121. The humidity sensor is provided at a bottom of the drainage groove 130. In this way, the condensate water on the drainage surface 121 can flow into the drainage groove 130 and be discharged from the heat dissipation boss plate 120 along the drainage groove 130.

The bottom of the drainage groove 130 can be a flat surface, a concave wedge-shaped surface, or a concave curved surface. When the bottom of the drainage groove 130 is a flat surface, the drainage groove 130 is easier to manufacture; when the bottom of the drainage groove 130 is a concave wedge-shaped surface or a concave curved surface, it is easier for condensate water to flow into the drainage groove 130 along a side wall of the drainage groove 130, which can accelerate the collection of the condensate water and render it accumulate into water droplets or a stream of water, and then be discharged from the drainage groove 130 fleetly.

In a specific application, after the heat dissipation plate 100 is assembled in the electric control box, a drainage direction of the drainage groove 130 is consistent with the gravity direction. This setting allows the condensate water entering the drainage groove 130 to flow along the drainage groove 130 under an action of gravity, which accelerates the discharge of these condensate water in the drainage groove 130 from the heat dissipation plate 100.

As shown in FIGs. 1 and 2, in the embodiments of the present disclosure, the accommodation area 170 is provided with a block 140, and the drainage groove 130 is formed between the block 140 and an adjacent heat dissipation boss plate 120.

An extension direction of the block 140 is consistent with the drainage direction of the drainage groove 130, the drainage groove 130 is formed between a side wall of the block 140 and a side wall of an adjacent heat dissipation boss plate 120. A surface of the block 140 facing away from the heat dissipation plate body 110 is flush with a surface of the heat dissipation boss plate 120 facing away from the heat dissipation plate body 110, so that when the heat dissipation plate 100 is assembled in the electric control box, the block 140 can also contact the ready-for-heat-dissipation electronic element in the electric control box, thereby increasing a contact area between the heat dissipation plate 100 and the ready-for-heat-dissipation electronic element in the electric control box, and improving a heat dissipation effect of the heat dissipation plate 100.

FIG. 7 is a structural schematic diagram of a heat dissipation component provided by an embodiment of the present disclosure. As shown in FIG. 7, the embodiment of the present disclosure further provides a heat dissipation component, which includes a heat exchanger 200 and the heat dissipation plate 100 for the electric control box according to the embodiments of the present disclosure. The heat exchanger 200 is arranged on a side of the heat dissipation plate 100 away from the heat dissipation boss plate 120, and the temperature-and-humidity sensor 160 is arranged between the heat dissipation plate 100 and the heat exchanger 200. The heat exchanger 200 is used for heat exchange with the heat dissipation plate 100, which allows heat on the heat dissipation plate 100 to be transferred outside the electric control box through the heat exchanger 200; and thus, reducing the temperature of the heat dissipation plate 100 and the temperature inside the electric control box.

The heat exchanger 200, to a certain extent, can function to regulate the temperature of the heat dissipation plate 100, as the heat dissipation plate 100 itself is used to exchange heat with the to-be-heat-dissipated electronic elements in the electric control box, and transfer the heat absorbed by these to-be-heat-dissipated electronic elements to the heat exchanger 200. The principle of heat exchange for the heat dissipation plate 100 is to utilize a temperature difference between the heat dissipation plate 100 itself and the ready-for-heat-dissipation electronic elements in the electric control box, to render transfer of heat on these electronic elements for heat dissipation to the heat dissipation plate 100, thus the heat dissipation plate 100 itself does not a have temperature regulation function. The temperature of the heat dissipation plate 100 depends on the heat exchange efficiency of the heat exchanger 200 to the heat dissipation plate 100 and the temperature of the electronic elements to be heat dissipated. Therefore, the heat exchange rate of the heat exchanger 200 to the heat dissipation plate 100 can be changed by adjusting the power of the heat exchanger 200, and in turn a cooling rate of the heat dissipation plate 100 can be adjusted, achieving indirect regulation of the temperature of the heat dissipation plate 100.

The heat exchanger 200 in the present disclosure can be a microchannel heat exchanger 200. The microchannel heat exchanger 200 includes at least two sets of microchannels. The at least two sets of microchannels include multiple first microchannels for flowing a first refrigerant stream and multiple second microchannels for flowing a second refrigerant stream. The second refrigerant stream absorbs heat from the first refrigerant stream to render undercooling of the first refrigerant stream, or the first refrigerant stream absorbs heat from the second refrigerant stream to render undercooling of the second refrigerant stream.

The microchannel heat exchanger 200 in the embodiments of the present disclosure can also serve as an economizer for an air conditioner. In this way, the microchannel heat exchanger 200 can be used to cool the electronic element inside the electric control box and also serve as the economizer, thereby avoiding a need to additionally provide an economizer outside the electric control box, to simplify the structure of the air conditioner, save space and costs.

In a specific application, the temperature-and-humidity sensor 160 of the heat dissipation plate 100 detects the temperature and humidity in an area near the heat dissipation plate 100. When the temperature sensor detects that the temperature and humidity in the area near the heat dissipation plate 100 meet a condition for the formation of condensate water, the power of the heat exchange component 200 may be reduced, thereby reducing the heat exchange rate of the heat exchanger 200 to the heat dissipation plate 100, which renders that the temperature of the heat dissipation plate 100 rises and that the temperature difference between the heat dissipation plate 100 and the air inside the electric control box be smaller, thus the air inside the electric control box is unable to meet the condition for the formation of condensate water when it comes into contact with the heat dissipation plate 100, preventing the formation of condensate water on the surface of the heat dissipation plate 100 and avoiding damage to the electronic elements inside the electric control box.

The heat exchanger 200 can be a heat dissipation tube arranged on a side of the heat dissipation plate 100 away from the heat dissipation boss plate 120. The heat dissipation plate 100 is in direct contact with a surface of the heat exchange tube, and a cooling medium is circulating and flowing inside the heat exchange tube.

When in use, the cooling medium circulating and flowing inside the heat exchange tube continuously exchanges heat with the heat exchange tube. The heat exchange tube contacts the heat dissipation plate 100 for heat exchange, which allows the heat on the heat dissipation plate 100 to be transferred to the cooling medium inside the heat exchange tube through the heat exchange tube, and the heat to be taken away from the electric control box through the circulation and flow of the cooling medium.

The heat exchanger 200 can also be a plate-type heat exchanger. The plate-type heat exchanger is a plate body with a flat surface, and a heat dissipation channel for the flowing of the cooling medium is provided inside the plate-type heat exchanger. The heat exchanger 200 is adhered to a surface on a side of the plate-type heat exchanger away from the heat dissipation boss plate 120.

When in use, the cooling medium is circulating and flowing in the heat dissipation channel, the cooling medium that circulates and flows inside the heat dissipation channel continuously exchanges heat with a shell of the plate-type heat exchanger. The shell of the plate-type heat exchanger contacts the heat dissipation plate 100 for heat exchange, which allows the heat on the heat dissipation plate 100 to be transferred, through the shell of the plate-type heat exchanger, to the cooling medium inside the heat exchange tube, and the heat to be taken away from the electric control box through the circulation and flow of the cooling medium.

Compared to the heat exchange tube, the plate-type heat exchanger, with a surface that is a plane surface, can be adhered more closely to the surface of the heat dissipation plate 100, which increases a contact area between the heat dissipation plate 100 and the plate-type heat exchanger, and renders the heat exchange in each area on the heat dissipation plate 100 more evenly, thus achieving a better heat exchange effect with the heat dissipation plate 100.

Furthermore, due to the fact that the surface of the plate-type heat exchanger can be adhered more closely to the surface of the heat dissipation plate 100, compared to the heat exchange tube, the plate-type heat exchanger can make full use of the cooling medium and reduce the waste of the cooling medium.

Specifically, the cooling medium circulating and flowing in the heat exchange tube and in the heat dissipation channel of the plate-type heat exchanger can be a fluid medium such as pure water, butene, ethylene glycol, etc.

Due to the fact that the heat dissipation component in the embodiments of the present disclosure adopts all technical solutions of the heat dissipation plate for the electric control box in the embodiments of the present disclosure, the heat dissipation component in the embodiments of the present disclosure has at least all the beneficial effects of the heat dissipation plate for the electric control box, and details will not be repeated here.

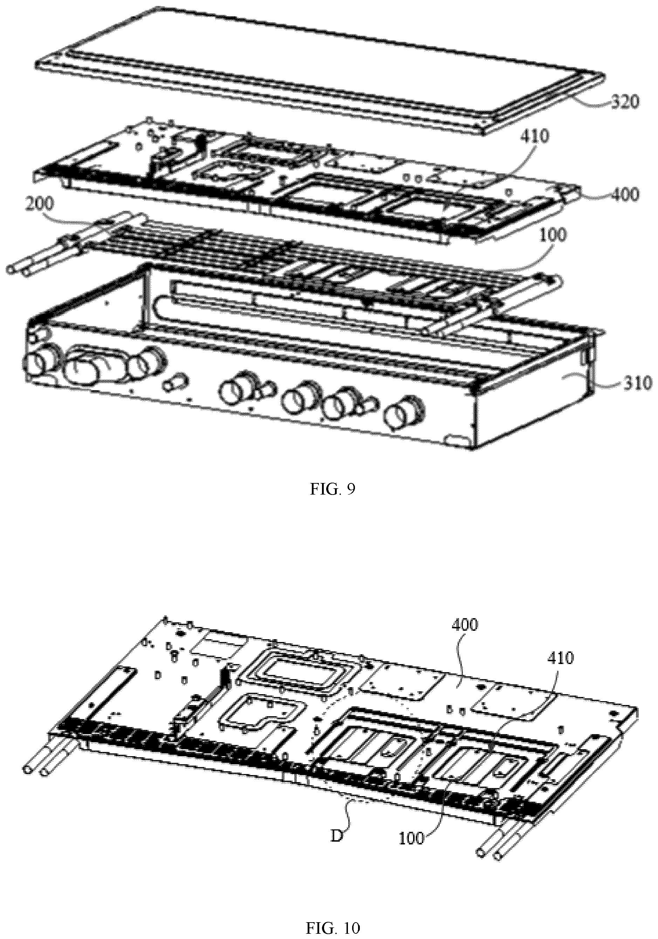

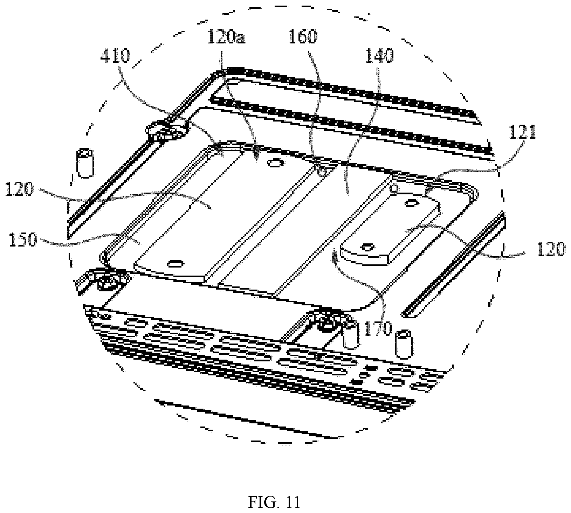

FIG. 8 is a structural schematic diagram of an electric control box provided by an embodiment of the present disclosure; FIG. 9 is an exploded schematic diagram of the electric control box provided by the embodiment of the present disclosure; FIG. 10 is a schematic diagram of a connection between the heat dissipation component and an installation plate in the electric control box provided by an embodiment of the present disclosure; FIG. 11 is an enlarged schematic diagram at position D in FIG. 10.

Referring to FIGs. 8 to 11, the embodiments of the present disclosure further provide an electric control box, which includes a box body 300, an installation plate 400, and the heat dissipation component of the embodiments of the present disclosure. The box body 300 includes a bottom box 310 and a box cover 320. The box cover 320 is matched on the bottom box 310 to form an accommodation cavity inside the box body 300. The accommodation cavity is mounted with an installation plate 400, a heat dissipation component, and other electronic elements.

The electric control box of the embodiments in the present disclosure can be a sealed electric control box, for example. This can prevent water droplets, dust, and other foreign objects from entering the electric control box to cause damage to the electronic elements inside the electric control box; and thus, achieving waterproof, dustproof, and anti-corrosion effects.

The installation plate 400 and the heat dissipation plate 100 of the heat dissipation component are arranged in layers inside the box body 300. The heat exchanger 200 of the heat dissipation component is arranged on a side of the heat dissipation plate 100 away from the installation plate 400. A surface of the installation plate 400 facing away from the heat dissipation plate 100 is used to install the electronic elements to be heat dissipated. The electronic elements to be heat dissipated can include a reactor, a filter board, and other electronic elements generating heat during operation that are mounted in the electric control box. In this way, the heat generated by the electronic elements to be heat dissipated will first be transferred to the installation plate 400, and then heat will be exchanged between the installation plate 400 and the heat dissipation plate 100 to transfer the heat to the heat dissipation plate 100. The heat on the heat dissipation plate 100 will come into contact with the heat exchanger 200 for heat exchange, and finally the heat will be discharged from the accommodation cavity through the cooling medium inside the heat exchanger 200.

It can be understood that the accommodation cavity of the box body 300 can also be provided with a circuit board, a connection cable, and other components that support the electric control box to achieve an electronic control function. A through hole (not shown) can be provided at a side wall of the box body 300, and the connection cable in the accommodation cavity of the box body 300 can be led out to the outside of the box body 300 through the through hole. An inlet pipeline and an outlet pipeline of the heat dissipation tube in the accommodation cavity of the box body 300 can also be led out to the outside of the box body 300 through the through hole.

It should be noted that in order to ensure the sealing of the box body 300, sealing is required among the connection cable, the inlet and outlet pipelines of the heat dissipation tube, and the through-hole. For example, a sealant can be provided among the connection cable, the inlet and outlet pipelines of the heat dissipation tube, and the through-hole, which ensures that the box body 300 is a sealed box body, thereby ensuring the sealing of the electric control box.

In a specific application, an installation sequence of the heat exchanger 200, the heat dissipation plate 100, and the installation plate 400 in the accommodation cavity of the box body 300 can also be adjusted according to an actual need. For example, the heat exchange tube, the heat dissipation plate 100, and the installation plate 400 can be arranged in layers sequentially in a direction pointing from the box cover 320 to a bottom wall of the bottom box 310.

In order to allow the heat dissipation plate 100 to effectuate direct heat dissipation for the ready-for-heat-dissipation electronic elements in the electric control box.

As shown in FIGs. 10 and 11, in the embodiments of the present disclosure, the heat dissipation plate body 110 is provided with a limit boss plate 150; both the limit boss plate 150 and the heat dissipation boss plate 120 are arranged on the same surface of the heat dissipation plate body 110, and the limit boss plate 150 is arranged between the heat dissipation plate body 110 and the heat dissipation boss plate 120. The installation plate 400 is provided with a limit notch 410 which is arranged to be opposite to the limit boss plate 150 of the heat dissipation plate 100. The limit boss plate 150 penetrates through the limit notch 410, and the temperature-and-humidity sensor 160 on the heat dissipation plate 100 is arranged in the limit notch 410. The limit boss plate 150 can penetrate the installation plate 400 through the limit notch 410 and extend out from a surface of the installation plate 400, which renders the surface of the heat dissipation boss plate 120 away from the heat dissipation plate body 110 to come into contact with a bottom surface of a ready-for-heat-dissipation element mounted on the installation plate 400; and thus, allowing the ready-for-heat-dissipation element to directly contact the heat dissipation boss plate 120 for heat exchange, improving the heat exchange efficiency between the heat dissipation plate 100 and the ready-for-heat-dissipation element, and thereby improving a heat dissipation effect of the heat dissipation plate 100.

In a specific application, a surface of the heat dissipation boss plate 120 facing away from the heat dissipation plate body 110 can be a plane surface, and a bottom surface of the element to be heat dissipated can also be a plane surface. This allows the surface of the heat dissipation boss plate 120 facing away from the heat dissipation plate body 110 to fit with the bottom surface of the element to be heat dissipated, so as to increase a contact area between the heat dissipation plate 100 and the element to be heat dissipated, and further improve the heat dissipation effect of the heat dissipation plate 100.

In addition, there can be multiple limit boss plates 150; the multiple limit boss plates 150 are arranged to be spaced apart on the heat dissipation plate body 110. This can enable more heat dissipation boss plates 120 to come into contact with the bottom surface of the ready-for-heat-dissipation element mounted on the installation plate 400, so as to improve the heat exchange efficiency between the heat dissipation plate 100 and the ready-for-heat-dissipation element.

Each one of the multiple limit boss plates 150 is provided with two heat dissipation boss plates 120; and on the same limit boss plate 150, two heat dissipation boss plates 120 are arranged to be spaced apart on the heat dissipation plate body 110. Two adjacently arranged heat dissipation boss plates 120 on the same limit boss plate 150 have an accommodation area 170 formed therebetween, and the accommodation area 170 formed between the two adjacently arranged heat dissipation boss plates 120 is provided with a temperature-and-humidity sensor 160. In this way, each limit boss plate 150 being provided with two heat dissipation boss plates 120 can reduce the number of limit notches 410 on the installation plate 400, improve the strength of the installation plate 400, and reduce the processing difficulty of the installation plate 400. Moreover, the accommodation area 170 formed between the two adjacently arranged heat dissipation boss plates 120 being provided with the temperature-and-humidity sensor 160 is equivalent to that each limit notch 410 is provided with the temperature-and-humidity sensor 160. This enables the temperature-and-humidity sensor 160 in each limit notch 410 can detect the temperature and humidity near a contact area between the heat dissipation plate 100 and each electronic element to be heat dissipated, thereby more accurately detecting whether there is a risk of forming condensate water in each area of the heat dissipation plate 100.

Due to the fact that the heat dissipation component of the embodiments of the present disclosure is used by the electric control box of the embodiments of the present disclosure, the electric control box of the embodiments of the present disclosure has at least all the beneficial effects of the heat dissipation component of the embodiments of the present disclosure, and details will not be repeated here.

The embodiments of the present disclosure further provide an air conditioner, which includes a main device and the electric control box of the embodiments of the present disclosure, and the electric control box is mounted on the main device. For example, the air conditioner can be a central air conditioner, and the electric control box can be used to control an operation of the air conditioner.

Since the air conditioner of the embodiments of the present disclosure adopts the electric control box of the embodiments of the present disclosure, the air conditioner of the embodiments of the present disclosure has at least all the beneficial effects of the electric control box of the embodiments of the present disclosure, and details will not be repeated here.

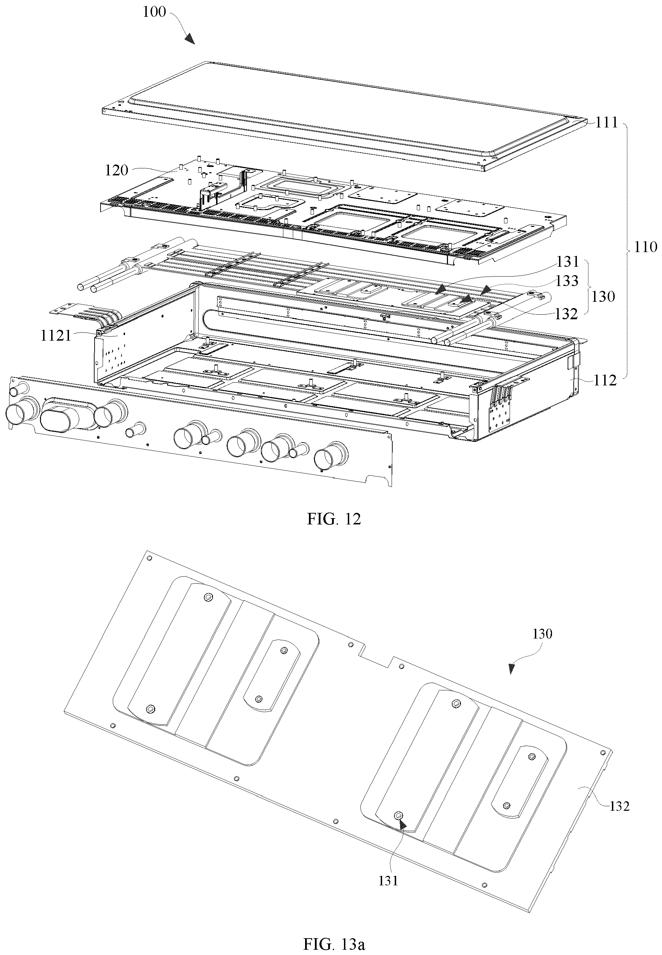

Please refer to FIG. 12, which is an exploded diagram of an electric control box provided by an embodiment of the present disclosure. As shown in FIG. 12, the embodiment of the present disclosure provides an electric control box 100, which includes a box body 110, where the box body 110 includes a box cover 111 and a box main body 112. The box main body 112 has an opening 1121; the box cover 111 covers the opening 1121. In some optional implementation modes, the box main body 112 is in a shape of cuboid, and the opening 1121 is in a shape of rectangular. The shape of the box cover 111 matches the shape of the opening 1121. In some other implementation modes, the electric control box 100 can also be in other shapes, and there are no specific restrictions on the shape of the electric control box 100.

Both the box body 110 and the box cover 111 can be sheet metal parts, and there are no specific restrictions on the material and processing technology of the box body 110 and the box cover 111.

It should be noted that the electric control box 100 of this embodiment can be a sealed electric control box, for example. This can prevent water droplets, dust, and other foreign objects from entering the electric control box to cause damage to the electronic element inside the electric control box; and thus, achieving waterproof, dustproof, and anti-corrosion effects.

The electric control box 100 provided in this embodiment further includes a retaining plate 120 and a heat dissipation plate component 130. The heat dissipation plate component 130 is detachably connected to a bottom of the box main body 112; a side of the heat dissipation plate component 130 facing the opening 1121 is provided with the retaining plate 120. The retaining plate 120 is used for providing different types of electronic elements, and is connected to a connector 131 of the heat dissipation plate component 130; a detachable connection with the heat dissipation plate component 130 can be achieved through the connector 131. When it is necessary to replace or repair an electronic element on the retaining plate 120, the retaining plate 120 can be removed from the heat dissipation plate component 130 to replace or repair the electronic element.

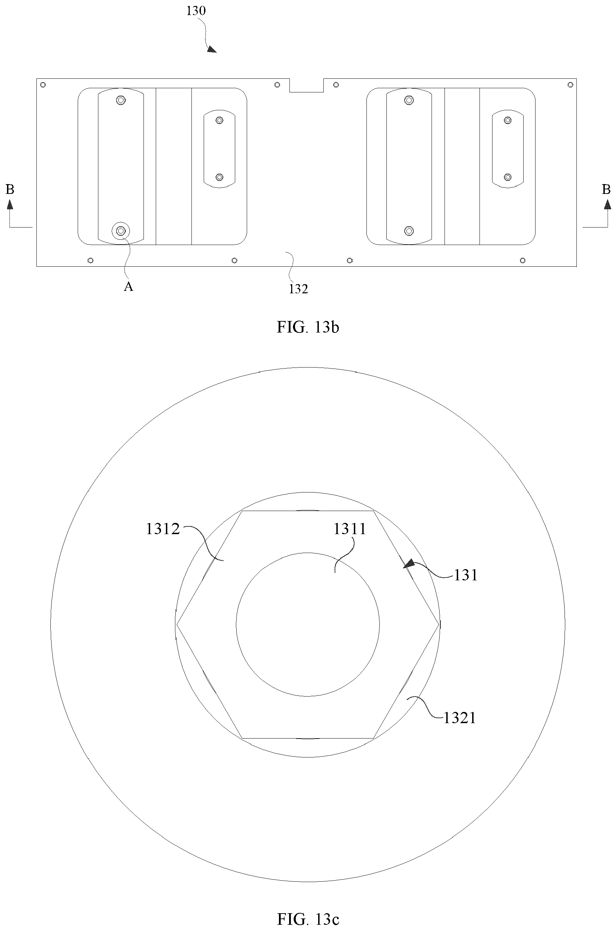

Please refer to FIGs. 13a to 13c, FIG. 13a is a three-dimensional structural diagram of a heat dissipation plate component provided by an embodiment of the present disclosure. FIG. 13b is a planar structural schematic diagram of the heat dissipation plate component provided by the embodiment of the present disclosure. FIG. 13c is an enlarged schematic diagram of a local structure at position A in FIG. 13b.

As shown in FIGs. 13a to 13c, the heat dissipation plate component 130 provided in this embodiment further includes a heat dissipation plate 132, which is provided with a connection hole 1321 that is axially perpendicular to an extension direction of a plate surface of the heat dissipation plate 132. The connector 131 is connected to the connection hole 1321 in a fitting mode, to fix the connector 131 on the heat dissipation plate 132. A hardness of the connector 131 is greater than a hardness of the heat dissipation plate 132. In a specific implementation mode of this embodiment, the heat dissipation plate 132 can be a plate-shaped component made of aluminum material; there is a threaded installation hole 1311 inside the connector 131. Specifically, the threaded installation hole 1311 penetrates through the connector 131 in its axial direction. An extension direction of the threaded installation hole 1311 and the extension direction of the connector 131 are consistent with an extension direction of the connection hole 1321. The retaining plate 120 is detachably connected to the connector 131 through the threaded installation hole 1311 to achieve a detachable connection between the retaining plate 120 and the heat dissipation plate component 130.

The heat dissipation plate component 130 provided in this embodiment is provided with the connection hole 1321; where the connector 131 with the threaded installation hole 1311 is embedded in the connector 131. The retaining plate 120 is detachably connected to the connector 131 through the threaded installation hole 1311 to achieve a detachable connection between the retaining plate 120 and the heat dissipation plate component 130. Therefore, it is possible to avoid a threaded hole to be provided directly on the heat dissipation plate 132, and a reliable connection between retaining plate 120 and heat dissipation plate component 130 can be achieved.

It should be noted that an inner wall of the connection hole 1321 mentioned above is a rotation surface, which means that the connection hole 1321 is an unthreaded hole. Compared to the threaded hole provided on the heat dissipation plate 132, providing the unthreaded hole on the heat dissipation plate 132 is easier to achieve in terms of process, which facilitates the processing and forming of the heat dissipation plate 132.

Furthermore, in this embodiment, the threaded installation hole 1311 mentioned above may have a pitch of 3mm or 4mm, or there may be other pitches that match the heat dissipation plate 132, no specific restrictions will be made to the axial and radial lengths of the connector 131.

In order to arrange the connector 131 on the heat dissipation plate 132, in this embodiment, the connector 131 is connected to the connection hole 1321 by means of clamping.

Specifically, the connector 131 can be press-fitted into the connection hole 1321 through press-fit equipment, such as riveting, inlaying, or spinning method. In this embodiment, there is no restriction on the specific press-fit method of the connector 131, as long as it can be ensured that the connector 131 is reliably press-fitted into the connection hole 1321.

In order to enable the connector 131 to be firmly fitted with the connection hole 1321, in a specific implementation mode of this embodiment, a circumferential side wall of the connector 131 is closely engaged with a side wall of the connection hole 1321. In this way, the connector 131 can be reliably fitted with the wall of the connection hole 1321, protecting the connector 131 from escaping from the connection hole 1321 after its movement.

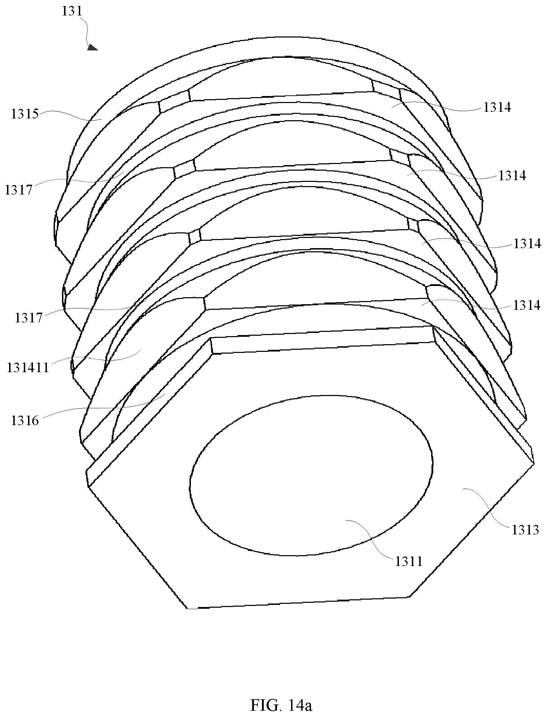

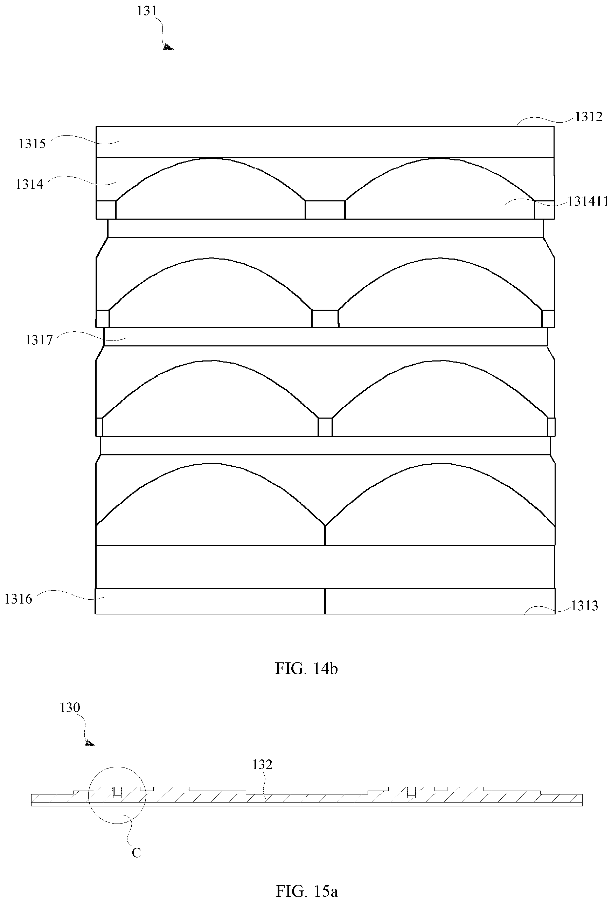

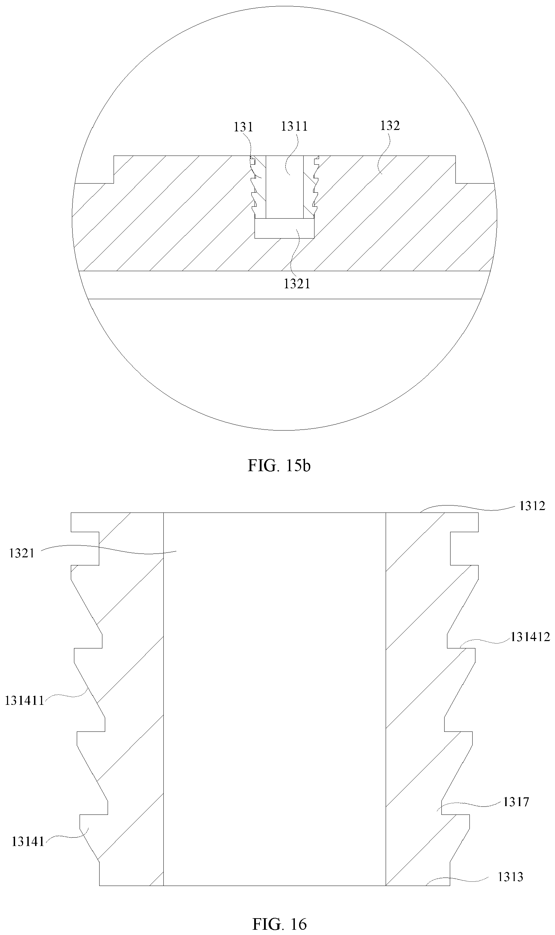

Please refer to FIGs. 13c to 14b, FIG. 14a is a three-dimensional structural schematic diagram of a connector in a heat dissipation plate component provided by an embodiment of the present disclosure. FIG. 14b is a planar structural schematic diagram of the connector in the heat dissipation plate component provided by the embodiment of the present disclosure. FIG. 15a is a cross-sectional view along B-B direction in FIG. 13b. FIG. 15b is an enlarged schematic diagram of a local structure at position C in FIG. 15a. As shown in FIGs. 13c to 15b, in a specific implementation mode of this embodiment, the connector 131 has a first end face 1312 in an axial direction of the connector 131. Furthermore, the connector 131 further has a second end face 1312, where the first end face 1312 is opposite to the second end face 1312, and the first end face 1312 is parallel to the second end face 1312.

In some optional implementation modes, the first end face 1312 and a plate surface of the heat dissipation plate 132 can be in the same plane, the first end face 1312 can also be arranged outside the plate surface of the heat dissipation plate 132, the second end face 1313 can be flush with a bottom of the connection hole 1321, or can be arranged on a side where the bottom of the connection hole 1321 faces the opening of the connection hole 1321.

In order to improve the overall aesthetics of the heat dissipation plate component 130 and reduce occupied space of the heat dissipation plate component 130, in this embodiment, the first end face 1312 and the plate surface of the heat dissipation plate 132 are on the same plane, and the second end face 1313 is arranged inside the connection hole 1321. That is to say, there is a certain distance between the second end face 1313 and the bottom of the connection hole 1321 in an axial direction of the connection hole 1321. In this way, by flushing the first end face 1312 with the plate surface of the heat dissipation plate 132, the surface of the heat dissipation plate 132 can be flat without any protruded structures, thereby improving the overall aesthetics of the heat dissipation plate component 130.

Specifically, for ease of explanation, a maximum radial length of the first end face 1312 in a radial direction of the threaded installation hole 1311 can be defined as a first maximum radial length, and a maximum radial length of the second end face 1313 is defined as a second maximum radial length. In order to press-fit the connector 131 into the connection hole 1321, in this embodiment, the first maximum radial length is greater than the second maximum radial length. Therefore, it is convenient to press-fit the connector 131 into the connection hole 1321, and thereby improving the smoothness of the connector 131 during installation.

In order to further improve the reliability of a connection between the connector 131 and the connection hole 1321, the connector 131 itself can have an anti-rotation function. The following will provide a detailed introduction to the connector 131 in the heat dissipation plate component 130 provided in this embodiment.

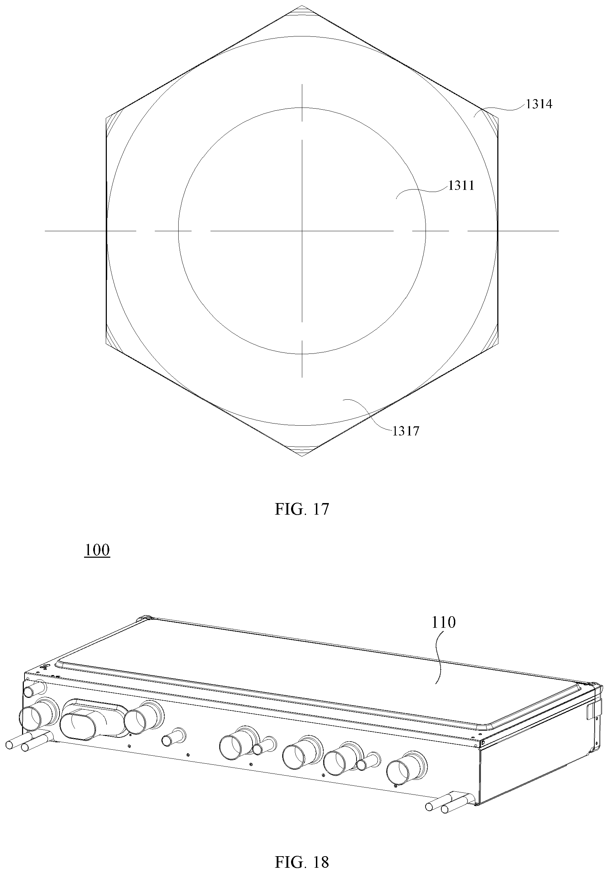

Please refer to FIGs. 14a, 14b, 16, and 17, FIG. 16 is a cross-sectional view of the connector in the heat dissipation plate component provided by an embodiment of the present disclosure. FIG. 17 is a partial structural schematic diagram of the connector in the heat dissipation plate component provided by an embodiment of the present disclosure. As shown in FIGs. 14a, 14b, 16, and 17, in a specific implementation mode of this embodiment, the connector 131 includes multiple sequentially connected anti-rotation units 1314, the multiple anti-rotation units 1314 are sequentially connected, and an arrangement direction of the multiple anti-rotation units 1314 is consistent with an axial direction of the threaded installation hole 1311. The anti-rotation unit 1314 has a projection surface in the axial direction of the connection hole 1321, and the projection surface is a non-circular surface.

It should be noted that the non-circular surface here can be of different shapes such as a polygon shape or a polygon-like shape. The polygon-like shape here can be a shape formed by connecting two adjacent sides in a polygon through an arc line, and each anti-rotation unit 1314 has a maximum radial length in a radial direction of the threaded installation hole 1311. The maximum radial length of each anti-rotation unit 1314 gradually decreases in a direction from the first end face 1312 to the second end face 1313. In this way, not only it is convenient to press-fit the connector 131 into the connection hole 1321, but also the connector 131 can be prevented from rotating in the connection hole 1321, which renders the press-fit connection between the connector 131 and the connection hole 1321 more reliable.

Specifically, the anti-rotation unit 1314 has multiple anti-rotation parts 13141, a distribution direction of the multiple anti-rotation parts 13141 is consistent with a circumferential direction of the connector 131, and only the multiple anti-rotation parts 13141 in the anti-rotation units 1314 close to the second end face 1313 are arranged to be adjacent to each other. In the remaining anti-rotation units 1314, the multiple anti-rotation parts 13141 are arranged to be spaced apart, and the anti-rotation parts 13141 have outer circumferential edges which are non-circular edges. By setting the anti-rotation parts 13141 with the outer circumferential edges being non-circular edges, a friction force between the connector 131 and the connection hole 1321 can be increased, and the rotation of the connector 131 in the connection hole 1321 can be prevented.

In order to facilitate the processing of the anti-rotation part 13141 and the processing and forming of the connector 131, in this embodiment, the anti-rotation part 13141 has an outer edge surface along its circumference side, and an extension direction of the anti-rotation part 13141 along its outer circumferential edge surface is consistent with an extension direction of a plane surface, so that an outer contour of a projection surface of the anti-rotation unit 1314 is polygonal in an axial direction of the connection hole 1321. In this way, it is convenient to process the outer circumferential edge surface of the anti-rotation part 13141, so as to facilitate the processing of the anti-rotation part 13141 and facilitate the processing and forming of the connector 131.

In order to protect the heat dissipation plate 132 from an excessive deformation under a condition that the anti-rotation unit 1314 can have an effective anti-rotation effect, in this embodiment, the anti-rotation unit 1314 has a projection surface in the axial direction of the connection hole 1321, and the projection surface of the anti-rotation unit 1314 has multiple maximum radial edges. In this embodiment, multiple maximum radial edges coincide on the same circumference, and in addition, in the axial direction of the connection hole 1321, the projection surfaces of the anti-rotation units 1314 have maximum radial edges; and the maximum radial edges of the projection surfaces of the individual anti-rotation units 1314 are arranged on circumferences that are equal. Here, the circumferences being equal can render an interpretation that the circumferences where the maximum radial edges of the projection surfaces of the individual anti-rotation units 1314 in the axial direction of the connection hole 1321 are arranged are the same circumference. In this way, not only the heat dissipation plate 132 can be prevented from excessive deformation, but also the maximum radial edges of the individual anti-rotation units 1314 can maintain consistency in shape, facilitating the processing and forming of the anti-rotation units 1314.

Furthermore, in the circumferential direction of the connector 131, multiple anti-rotation parts 13141 are symmetrically distributed; the multiple anti-rotation parts 13141 are uniformly distributed. In this way, during the process of processing and manufacturing the anti-rotation units 1314, it is not only convenient to determine a position of each anti-rotation part 13141, but also convenient to process and manufacture each anti-rotation part 13141.

Furthermore, in order to facilitate the combination and connection of various anti-rotation units 1314 together, in this embodiment, the anti-rotation parts 13141 in each anti-rotation unit 1314 have the same position in the circumferential direction of the connector 131. That is to say, if at a certain determined position of the connector 131 in the circumferential direction thereof, there is an anti-rotation part 13141 of a certain anti rotation unit 1314, then along an axial direction of the threaded installation hole 1311, and at this position, there are also anti-rotation parts 13141 of other anti-rotation units 1314 at this position.

In order to enable the anti-rotation part 13141 to have an effective anti-rotation effect, special restrictions have been made on a structure of the anti-rotation part 13141 in this embodiment. The following is a detailed introduction to the structure of the anti-rotation part 13141.

As shown in FIGs. 14a, 14b, and 16, the anti-rotation part 13141 has a guide surface 131411 facing the second end face 1313. There is an included angle between an extension direction of the guide surface 131411 and the axial direction of the connector 131. If the second end face 1313 is taken as a bottom surface and the first end face 1312 is taken as a top surface, an outer side of the guide surface 131411 should be higher than an inner side of the guide surface 131411. By providing the guide surface 131411, a friction force between the anti-rotation part 13141 and the connection hole 1321 can be increased; and thus, preventing the connector 131 from rotating in the connection hole 1321.

In order to prevent the connector 131 from moving in an axial direction of the connection hole 1321; in a specific implementation mode of this embodiment, the anti-rotation part 13141 further has a stop surface 131412 which is provided on a side of the guide surface 131411 facing away from the second end face 1313, and an extension direction of the stop surface 131412 is consistent with a radial direction of the connection hole 1321. In this way, by providing the stop surface 131412, a relative position between the connector 131 and the heat dissipation plate 132 can be limited in the axial direction of the connection hole 1321, to prevent the connector 131 from moving in the axial direction of the connection hole 1321.

Specifically, the stop surface 131412 is parallel to the first end face 1312, which means that the stop surface 131412 is parallel to the second end face 1313. This facilitates the processing and forming of the anti-rotation part 13141, and reduces the manufacturing cost of the connector 131.

In order to improve the structural stability of the connector 131, the connector 131 further includes a first support portion 1315 and, furthermore, the connector 131 further includes a second support portion 1316, and the first support portion 1315 is arranged opposite to the second support portion 1316.

Specifically, in the axial direction of the threaded installation hole 1311, the first support portion 1315 positionally corresponds to the first end face 1313, and the second support portion 1316 positionally corresponds to the second end face 1313, so that the first end face 1312 is formed at an end of the first support portion 1315 facing away from the second support portion 1316, and the second end face 1313 is formed at an end of the second support portion 1316 facing away from the first support portion 1315; multiple anti-rotation units 1314 are arranged between the first support portion 1315 and the second support portion 1316. In this way, by providing with the first support portion 1315 and the second support portion 1316, it is possible to provide a certain support for multiple anti-rotation units 1314 and improve the structural stability of the connector 131.

In a specific implementation mode of this embodiment, in the axial direction of the connection hole 1321, an outer contour of a projection surface of the first end face 1312 is a first outer contour, and an outer contour of a projection surface of the second end face 1313 is a second outer contour. The first outer contour is circular, and the second outer contour is polygonal. In some other implementation modes, the first outer contour and the second outer contour can also be in other shapes, there are no specific restrictions on the shape of the first and second outer contours.

Furthermore, the connector 131 further has multiple connection parts 1317 that are arranged to be spaced apart in the axial direction of the connection hole 1321. The number of connection parts 1317 is the same as the number of anti-rotation units 1314, so that the connection parts 1317 correspond to the anti-rotation units 1314. In a specific implementation mode of this embodiment, a connection part 1317 is arranged between the first support portion 1315 and the anti-rotation unit 1314 close to the first support portion 1315, the remaining connection parts 1317 are arranged between two adjacently arranged anti-rotation units 1314. This renders the structure of the connector 131 more stable.

As shown in FIG. 12, in order to improve the heat dissipation performance of the heat dissipation plate component 130 provided in this embodiment, in a specific implementation mode of this embodiment, the heat dissipation plate component 130 further includes a microchannel heat exchanger 133. Specifically, the microchannel heat exchanger 133 includes at least two sets of microchannels. The at least two sets of microchannels include multiple first microchannels for flowing a first refrigerant stream and multiple second microchannels for flowing a second refrigerant stream, the second refrigerant stream absorbs heat from the first refrigerant stream to render undercooling of the first refrigerant stream, or the first refrigerant stream absorbs heat from the second refrigerant stream to render undercooling of the second refrigerant stream.

This embodiment further provides an electric control box, its specific structure can be referred to the structure of the electric control box shown in FIG. 12. The electric control box 100 provided in this embodiment includes a retaining plate 120 and a heat dissipation plate component 130. The specific structure, function, and working principle of the heat dissipation plate component 130 have been explained in detail in the previous description of the present embodiments, so details will not be repeated here.

Specifically, as shown in FIG. 12, the heat dissipation plate component 130 is detachably connected to a bottom of the box main body 112, and a side of the heat dissipation plate component 130 facing the opening 1121 is provided with a retaining plate 120. The retaining plate 120 is used to provide different types of electronic elements, and is connected to the connector 131 of the heat dissipation plate component 130, to achieve a detachable connection with the heat dissipation plate component 130 through the connector 131. When it is necessary to replace or repair the electronic element on the retaining plate 120, the retaining plate 120 can be removed from the heat dissipation plate component 130 to replace or repair the electronic element.

In the electric control box 100 provided in this embodiment, during an assembly process of the electric control box 100, when the heat dissipation plate component 130 is connected with the retaining plate 120 for installation, the connector 131 is firstly aligned with the connection hole 1321 on the heat dissipation plate 132, and then the connector 131 is press-fitted into the connection hole 1321 through press-fit equipment, to render a top surface of the connector 131 to be flush with a plate surface of the heat dissipation plate 132. Then, the retaining plate 120 is placed on the heat dissipation plate component 130, threaded fasteners with the same number of connection holes 1321 are used, such as screws, to make the threaded fasteners penetrate through the retaining plate 120 and the threaded installation holes 1311 in sequence, to achieve a detachable connection between the heat dissipation plate component 130 and the retaining plate 120.

It should be noted that in order to achieve a normal operation of the electric control box, the electric control box provided in this embodiment should further include other components or parts. Here, other components or parts in the electric control box provided in this embodiment will not be introduced in detail.

This embodiment further provides an outdoor air conditioning unit, which includes the electric control box 100 in the description previous to this embodiment. The specific structure, function, and working principle of the electric control box 100 have been explained in detail in the description previous to this embodiment, so details will not be repeated here.

In the outdoor air conditioning unit provided in this embodiment, the electric control box 100 can be arranged inside the outdoor air conditioning unit, and the electronic elements and the circuit board inside the electric control box 100 can be connected to other parts inside the outdoor air conditioning unit through cables and other electrical connection wires, to control the operation of the outdoor air conditioning unit.

It should be noted that the outdoor air conditioning unit provided in this embodiment should further include other components or parts to ensure the normal operation of the outdoor air conditioning unit. However, other components or parts in the outdoor air conditioning unit provided in this embodiment will not be introduced in detail.

This embodiment further provides an air conditioner, which can be a central air conditioner. The air conditioner provided in this embodiment includes the outdoor air conditioning unit mentioned in the description previous to this embodiment. The specific structures, functions, and working principles of the outdoor air conditioning unit, and the electric control box and other components included inside the outdoor air conditioning unit have been explained in detail in the description previous to this embodiment, and details will not be repeated here.

In the air conditioner of this embodiment, in addition to the outdoor air conditioning unit, it further includes parts such as an indoor air conditioning unit. The outdoor air conditioning unit is arranged outdoors, and the indoor air conditioning unit is arranged indoors. The indoor air conditioning unit is connected to the outdoor air conditioning unit through pipelines, and heat exchange is carried out between the outdoor air conditioning unit and the indoor air conditioning unit, so as to cool or heat the indoor of the house.

In the air conditioner provided in this embodiment, the microchannel heat exchanger mentioned above can serve as an economizer of the air conditioner. In this way, the microchannel heat exchanger not only can be used to cool an electronic element inside the electric control box 100, but also serves as the economizer, thereby avoiding a need to additionally provide an economizer outside the electric control box 100 to simplify the structure of the air conditioner, save space and costs.

It should be noted that the air conditioner provided in this embodiment should further include other components or parts to ensure a normal operation of the air conditioner. However, no detailed introduction will be given to other components or parts in the air conditioner provided in this embodiment.

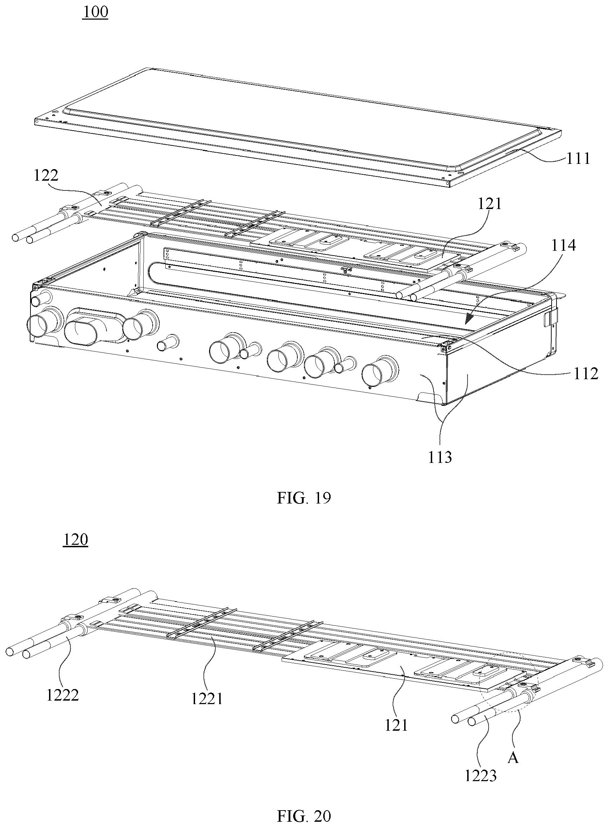

FIG. 18 is a structural schematic diagram of the electric control box provided by an embodiment of the present disclosure; FIG. 19 is an exploded structural view of the electric control box provided by the embodiment of the present disclosure. As shown in FIGs. 18 and 19, the electric control box 100 can include a box body 110, where the box body 110 can include a bottom wall 112, a side wall 113, and a box cover 111. The side wall 113 is arranged around the bottom wall 112 along a circumferential direction of the bottom wall 112, the box cover 111 is closed at an end of the side wall 113 far away from the bottom wall 112, so that an accommodation cavity 114 is enclosed by the bottom wall 112, the side wall 113, and the box cover 111 together.

The electric control box of the embodiment in the present disclosure can be a sealed electric control box, for example. This can prevent water droplets, dust, and other foreign objects from entering the electric control box to cause damage to the electronic element inside the electric control box; and thus, achieving waterproof, dustproof, and anti-corrosion effects.

The heat exchanger in the present disclosure can be a microchannel heat exchanger (a set of heat exchange tubes 122). The microchannel heat exchanger includes at least two sets of microchannels. The at least two sets of microchannels include multiple first microchannels for flowing a first refrigerant stream and multiple second microchannels for flowing a second refrigerant stream. The second refrigerant stream absorbs heat from the first refrigerant stream to render undercooling of the first refrigerant stream, or the first refrigerant stream absorbs heat from the second refrigerant stream to render undercooling of the second refrigerant stream.

The microchannel heat exchanger of the embodiments of the present disclosure can also serve as an economizer of the air conditioner. In this way, the microchannel heat exchanger can be used not only to cool an electronic element inside the electric control box, but also be used as the economizer, thereby avoiding a need to additionally provide an economizer outside the electric control box, to simplify the structure of the air conditioner, save space and costs.

The electric control box 100 can further include a heat exchange tube component 122, an installation plate for an electric appliance (not shown in the drawing), and a heat dissipation plate 121. The heat exchange tube component 122, the installation plate for an electric appliance, and the heat dissipation plate 121 are all accommodated in an accommodation cavity 114 of the box body 110. For example, the heat exchange tube component 122 can be mounted in the accommodation cavity 114 of the box body 110 in such a manner that it is close to a bottom wall 112 of the box body 110. The heat dissipation plate 121 can be stacked on a side of the heat dissipation tube component 122 facing away the bottom wall 112, and the installation plate for the electric appliance can be stacked on a side of the heat dissipation plate 121 facing away from the heat exchange tube component 122. A surface of the installation plate for the electric appliance facing away from the heat dissipation plate 121 is mounted with an electronic element (not shown in the drawing), and the electronic element can include a presser, a fan, a filter, an electronic controller, and other electronic elements required for the operation of the electric control box 100.

It can be understood that an installation sequence of the heat exchange tube component 122, the installation plate for the electric appliance, and the heat dissipation plate 121 in the accommodation cavity 114 of the box body 110 can also be adjusted according to actual needs. For example, the heat exchange tube component 122, the installation plate for the electric appliance, and the heat dissipation plate 121 can be arranged in layers sequentially in a direction pointing from the box cover 111 to the bottom wall 112. The heat exchange tube component 122 can include one heat exchange tube 1221, two heat exchange tubes 1221, or multiple heat exchange tubes 1221. For example, one heat exchange tube 1221 can be coiled in an "S" shape and form a heat exchange surface, two or more heat exchange tubes 1221 can be arranged in parallel and form the heat exchange surface; the heat dissipation plate 121 covers the heat exchange surface formed by the arrangement of the heat exchange tubes 1221, for heat exchange with the heat exchange tubes 1221.

The accommodation cavity 114 of the box body 110 can also be provided with a circuit board (not shown in the drawing), a connection cable (not shown in the drawing), and other components that support an electronic control function of the electric control box 100. A through hole can be provided on a side wall 113 of the box body 110, and the connection cable inside the accommodation cavity 114 of the box body 110 can be led out to the outside of the box body 110 through the through hole. The heat exchange tube component 122 can include a refrigerant inlet pipeline and a refrigerant outlet pipeline, the refrigerant inlet pipeline and refrigerant outlet pipeline can also be led out to the outside of the box body 110 through the through hole, so that part of the structure of the heat exchange tube component is arranged inside the electric control box, and part of the structure extends to the outside of the electric control.

Next, an explanation will be given to the heat dissipation component 120 including the heat exchange tube component 122 and the heat dissipation plate 121. It can be understood that the heat dissipation component 120 in the following description is not limited to being applied to the electric control box 100 of the embodiments of the present disclosure, but can also be applied to other devices that require heat dissipation.

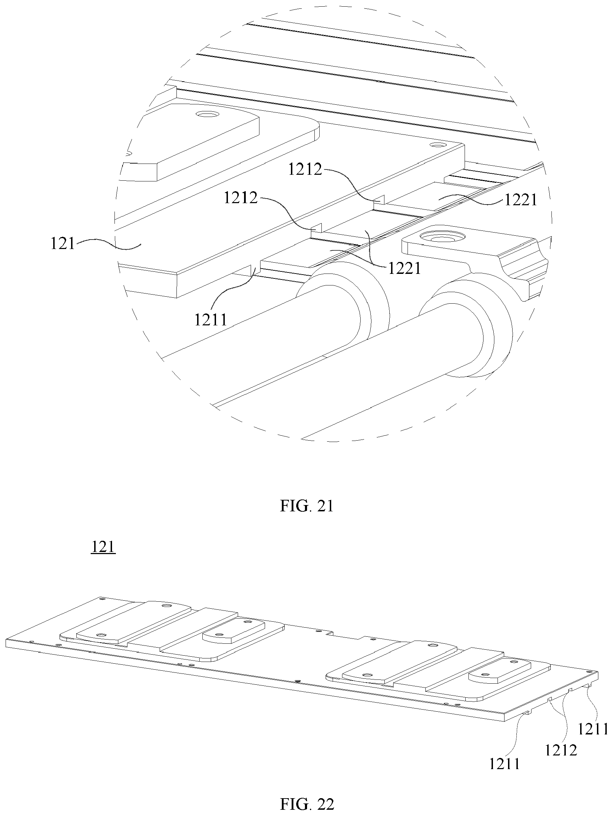

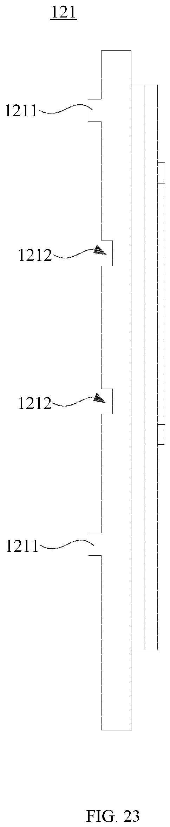

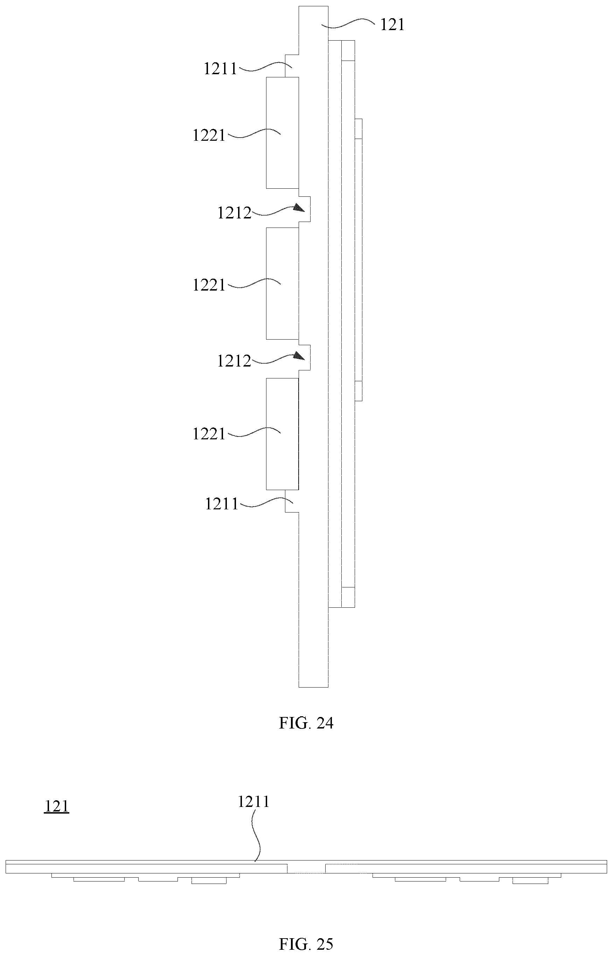

FIG. 20 shows a structural schematic diagram of the heat dissipation component provided by an embodiment of the present disclosure; FIG. 21 shows an enlarged view at position A in FIG. 20; FIG. 22 shows a structural schematic diagram of a heat dissipation plate provided by the embodiment of the present disclosure; FIG. 23 shows a side view of the heat dissipation plate provided by the embodiment of the present disclosure; FIG. 24 is a side view schematic diagram of a relative position of the heat dissipation plate with a heat exchange tube provided by the embodiment of the present disclosure; FIG. 25 is a top view of the heat dissipation plate provided by the embodiment of the present disclosure.

Referring to FIGs. 20 to 25, the embodiments of the present disclosure provide a heat dissipation component 120, which includes a heat exchange tube component 122 and a heat dissipation plate 121. The heat dissipation plate 121 and the heat exchange tube component 122 are arranged in layers and in contact with each other, that is, a surface of the heat exchange tube component 120 facing the heat dissipation plate 121 is in contact with a surface of the heat dissipation plate 121 facing the heat exchange tube component 122, so that the heat dissipation plate 121 can transfer heat to the heat exchange tube component 122 through a contact surface between the heat dissipation plate 121 and the heat exchange tube component 122.

The heat dissipation plate 121 is provided with a limit rib 1211 protruding towards a side where the heat exchange tube component 122 is arranged; and an extension direction of the limit rib 1211 is consistent with an extension direction of the heat exchange tube component 122. For example, when the heat exchange tubes of the heat exchange tube component 122 are arranged to be parallel, the extension direction of the heat exchange tube component 122 can be an extension direction of the heat exchange tube; alternatively, the extension direction of the heat exchange tube component 122 can also be an extension direction of an edge of the heat exchange tube component 122. In a first possible implementation mode, in the extension direction of the heat exchange tube component 122, the limit rib 1211 can extend in such a manner that its two ends are flush with two ends of the heat dissipation plate 121. In a second possible implementation mode, in the extension direction of the heat exchange tube component 122, the limit rib 1211 can extend in such a manner that one end thereof is flush with an end of the heat dissipation plate 121 and the other end of the limit rib 1211 can extend and stop within a plate surface of the heat dissipation plate 121. In a third possible implementation mode, in the extension direction of the heat exchange tube component 122, both ends of the limit rib 1211 can extend and stop within the plate surface of the heat dissipation plate 121.

In addition, in the extension direction of the heat exchange tube component 122, the limit rib 1211 can include two or more limit rib 1211 sections that are arranged to be spaced apart; the multiple limit rib 1211 sections can be arranged at an equal interval or an unequal interval. The interval between two or more limit rib 1211 sections can be used to avoid a connection structure on the heat exchange tube component 122.

A side surface of the heat exchange tube component 122 facing the limit rib 1211 abuts against a side surface of the limit rib 1211 facing the heat exchange tube component 122; that is, the limit rib 1211 can position the heat dissipation plate 121 and the heat exchange tube component 122 to determine a relative position between the heat dissipation plate 121 and the heat exchange tube component 122. At the same time, a relative angle between the heat dissipation plate 121 and the heat exchange tube component 122 is determined, as so to ensure that the heat dissipation plate 121 and the heat exchange tube component 122 do not tilt after being assembled together.

The limit rib 1211 and the heat dissipation plate 121 are an integrated part. For example, the limit rib 1211 and the heat dissipation plate 121 can be an integrated part formed by machining a piece of material through a turning, milling, planning, grinding, or extrusion forming process. Of course, the limit rib 1211 and the heat dissipation plate 121 can also be formed into an integrated part through other processes known to those skilled in the art.

In one possible implementation mode, the limit rib 1211 is an aluminum limit rib 1211, and the heat dissipation plate 121 is an aluminum heat dissipation plate 121. During the processing, an aluminum sheet can be extruded to form the heat dissipation plate 121 with the limit rib 1211, that is, the limit rib 1211 and the heat dissipation plate 121 are an integrated part formed by extrusion. On the one hand, the extrusion molding process is convenient to operate and is conducive to improving the processing efficiency of the heat dissipation plate 121; on the other hand, the heat dissipation plate 121, formed by extrusion, with a limit rib 1211 not only is conducive to ensuring the reliability of a connection between the limit rib 1211 and the heat dissipation plate 121, but also ensures a certainty of a position of the limit rib 1211 on the heat dissipation plate 121, thereby facilitating the reliability of mutual positioning between the heat dissipation plate 121 and the heat exchange tube component 122.

The embodiments of the present disclosure involve providing the heat dissipation component 120 which includes the heat exchange tube component 122 and the heat dissipation plate 121, arranging the heat dissipation plate 121 and the heat exchange tube component 122 in layers, and contacting a surface of the heat exchange tube component 122 that faces the heat dissipation plate 121 with a surface of the heat dissipation plate 121 that faces the heat exchange tube component 122, so that heat on the heat dissipation plate 121 can be transferred to the heat exchange tube component 122 through a contact surface between the heat dissipation plate 121 and the heat exchange tube component 122, and the heat is dissipated by the heat exchange tube component 122, so that heat generated by the electronic element in the electric control box 100 during operation can be transferred outwards through the heat dissipation component 120 to improve the reliability of the operation of the electronic element.

At the same time, a limit rib 1211 is provided on the heat dissipation plate 121, a surface of the limit rib 1211 faces a surface where the heat exchange tube component 122 is arranged, the extension direction of the limit rib 1211 is rendered to be consistent with the extension direction of the heat exchange tube component 122; and the side of the heat exchange tube component 122 facing the limit rib 1211 abuts against the side of the limit rib 1211 facing the heat exchange tube component 122, so that the limit rib 1211 can play a positioning role between the heat dissipation plate 121 and the heat exchange tube component 122, to ensure the stability of the position and angle of the heat dissipation plate 121 relative to the heat exchange tube component 122, and to prevent from tilting after assembly. Moreover, by providing the limit rib 1211 and the heat dissipation plate 121 as an integral part, it is not only beneficial to reduce the number of parts and simplify the structure of the heat dissipation plate 121, but also to improve the structural strength and reliability of a connection between the limit rib 1211 and the heat dissipation plate 121.

As shown in FIGs. 21 and 24, a top of the limit rib 1211 is lower than a surface of the heat exchange tube component 122 away from the heat dissipation plate 121, or the top of the limit rib 1211 is flush with a surface of the heat exchange tube component 122 away from the heat dissipation plate 121, which is not only beneficial for saving materials, but also for saving space and reducing installation interference.

In a specific application, when the heat exchange component can be mounted in the accommodation cavity 114 of the electric control box 100, a surface of the heat exchange tube component 122 away from the heat dissipation plate 121 can be mounted towards the bottom wall 112 of the box body 110. At this time, by providing the top of the limit rib 1211 to be lower than the surface of the heat exchange tube component 122 away from the heat dissipation plate 121, or by providing the top of the limit rib 1211 to be flush with the surface of the heat exchange tube component 122 away from the heat dissipation plate 121, which may avoid interference between a protruding height of the limit rib 1211 and the bottom wall 112 of the box body 110, so as to ensure a smooth installation of the heat exchange tube component 122 and the bottom wall 112 of the box body 110.

As shown in FIGs. 21 and 24, the heat exchange tube component can include one heat exchange tube, two heat exchange tubes, or more heat exchange tubes. The limit rib 1211 includes at least two, the at least two limit ribs 1211 are arranged to be spaced apart. For example, the at least two limit ribs 1211 can be arranged at equal intervals or unequal intervals. At least one heat exchange tube 1221 is clamped between two adjacent limit ribs 1211. For example, one heat exchange tube 1221, two heat exchange tubes 1221, or more heat exchange tubes 1221 can be clamped between two adjacent limit ribs 1211 according to an actual need. A spacing between the two adjacent limit ribs 1211 can be set according to the number of heat exchange tubes 1221 that need to be clamped. Increasing the number of limit ribs 1211 can have a better positioning effect, which is conducive to further improving the stability of an installation between the heat dissipation plate 121 and the heat exchange tube component 122, thereby better preventing the heat dissipation plate 121 from being tilted.

In one possible implementation mode, it is possible to provide two limit ribs 1211; the two limit ribs 1211 may be provided therebetween with three heat exchange tubes 1221 that are arranged side by side. The two limit ribs 1211 respectively abuts against two sides of the three heat exchange tubes 1221 that are arranged side by side so as to position the heat dissipation plate 121 on the heat exchange tube 1221; and thus, determining a relative angle and a relative position between the heat dissipation plate 121 and the heat exchange tube component 122.

In another possible implementation mode, it is possible to provide more limit ribs 1211; a heat exchange tube 1221 can be clamped between two adjacent limit ribs 1211. This not only facilitates better locating of a relative angle and a relative position between the heat exchange tube 1221 and the heat dissipation plate 121, but also increases the contact area between the heat exchange tube 1221 and the heat dissipation plate 121 to improve a thermal conductivity effect between the heat exchange tube 1221 and the heat dissipation plate 121.

It can be understood that the number and arrangement of limit ribs 1211, the spacing between two adjacent limit ribs 1211, and the number of heat exchange tubes 1221 clamped between two adjacent limit ribs 1211 are not limited to the two possible implementation modes mentioned above. Setting is possible according to an actual need in a specific application.

As shown in FIGs. 20, 21, and 24, the heat exchange tube component 122 includes at least two heat exchange tubes 1221. For example, the number of heat exchange tubes 1221 can be set to two, three, four, five, seven, or more according to an actual need. In a plane parallel to the heat dissipation plate 121, at least two heat exchange tubes 1221 are parallel to each other and are arranged to be spaced apart, to form the heat exchange tube component 122, which is beneficial for increasing the contact area between the heat dissipation plate 121 and the heat exchange tube 1221, thereby improving the heat transfer efficiency and heat transfer effect between the heat exchange tube 1221 and the heat dissipation plate 121.

As an example, seven heat exchange tubes 1221 are included, which, in the plane surface parallel to the heat dissipation plate 121, are parallel to each other and arranged to be spaced apart to form the heat exchange tube component 122. The heat dissipation plate 121 covers the surface of the heat exchange tube component 122 and contacts multiple heat exchange tubes 1221 in the heat exchange tube component 122 at the same time, thereby facilitating a rapid transfer of heat from different positions of the heat dissipation plate 121 to the heat exchange tubes 1221 of the heat exchange tube component 122, and thus it is beneficial to improve the heat dissipation efficiency of the heat dissipation component 120.

As shown in FIGs. 20, 21, and 24, a surface of the heat dissipation plate 121 is provided with a groove 1212, and an opening of the groove 1212 faces towards a direction where the heat exchange tube 1221 is arranged. The extension direction of the groove 1212 is consistent with the extension direction of the heat exchange tube 1221, and the groove 1212 is arranged between two adjacent heat exchange tubes 1221.

In a first possible implementation mode, in the extension direction of the heat exchange tube 1221, both ends of the groove 1212 can extend to both ends of the heat dissipation plate 121. In a second possible implementation mode, in the extension direction of the heat exchange tube 1221, one end of the groove 1212 can extend to an end of the heat dissipation plate 121, and the other end of the groove 1212 can extend and stop within the plate surface of the heat dissipation plate 121. In a third possible implementation mode, in the extension direction of the heat exchange tube 1221, both ends of the limit rib 1211 can extend and stop within the plate surface of the heat dissipation plate 121.

In a specific application, during the process of welding the heat exchange tube 1221 and the heat dissipation plate 121 together, first, a welding flux is applied on the surface of the heat exchange tube 1221 facing the heat dissipation plate 121, and the heat exchange tube 1221 and the heat dissipation plate 121 are fixed together through a fixture or other parts. Then, the fixed heat exchange tube 1221 and the heat dissipation plate 121 are placed together in a heating device for heating, to melt the welding flux, so that the heat dissipation plate 121 and the heat exchange tube 1221 are in a welding connection. During a heating process, the groove 1212 on the heat dissipation plate 121 allows for quickly and evenly heating a middle area of the heat dissipation plate 121 along a thickness direction of the heat dissipation plate 121, which is beneficial for improving the quality of welding between the heat dissipation plate 121 and the heat exchange tube 1221.

As shown in FIG. 24, a width of a spacing between two adjacent heat exchange tubes 1221 is greater than or equal to a width of the groove 1212. On the one hand, it can be ensured that a surface of the heat exchange tube 1221 facing the heat dissipation plate 121 is completely in contact with the heat dissipation plate 121, which is conducive to ensuring the heat transfer efficiency and heat transfer effect between the heat exchange tube 1221 and the heat dissipation plate 121; on the other hand, when connecting the heat dissipation plate 121 and the heat exchange tube 1221 by means of welding, it can be ensured that a contact surface during welding between the heat dissipation plate 121 and the heat exchange tube 1221 is relatively large, which is conducive to ensuring the strength and reliability of the connection between the heat exchange tube 1221 and the heat dissipation plate 121 during welding.

Furthermore, in order to ensure that the strength of the heat dissipation plate 121 at the groove 1212 meets the requirements, the depth of the groove 1212 can be set to be less than or equal to 1/2 of the thickness of the heat dissipation plate 121. For example, the depth of the groove 1212 can be equal to a half of the thickness of the heat dissipation plate 121, or the depth of the groove 1212 can be equal to one-third of the thickness of the heat dissipation plate 121, or the depth of the groove 1212 can be set to any value that is less than or equal to 1/2 of the thickness of the heat dissipation plate 121 according to an actual need. Thus, the groove 1212 not only can allow for rapid and evenly heating the heat dissipation plate 121, to achieve the purpose of improving the welding quality, but also it can prevent the structural strength of the heat dissipation plate 121 from being affected due to an excessive depth of the groove 1212; at the same time, it can also prevent the thickness of the heat dissipation plate 121 at the bottom of the groove 1212 from being too small, which may cause overheating during the welding and heating process.

In one possible implementation mode, the heat exchange tube 1221 can be a microchannel flat tube, which has a relatively large flat surface, the heat dissipation plate 121 is in contact with the flat surface of the microchannel flat tube. On the one hand, the flat surface of the microchannel flat tube is conducive to increasing a contact area between the heat exchange tube 1221 and the heat dissipation plate 121, so as to ensure the heat conduction effect between the heat exchange tube 1221 and the heat dissipation plate 121; on the other hand, the microchannel flat tube not only saves refrigerant consumption, but also have a high heat transfer coefficient and a good heat transfer effect.

In other possible implementation modes, the heat exchange tube 1221 can also be a simple flat tube. The heat dissipation plate 121 contacts and transfers heat to the flat surface of the flat tube, the flat tube is filled with refrigerant to achieve the cooling function of the heat exchange tube 1221. In addition, the heat exchange tube 1221 has a cross-sectional shape including but not limited to a rectangular, a circular, an elliptical, and a trapezoid.

A surface of the heat exchange tube 1221 facing the heat dissipation plate 121 and a surface of the heat dissipation plate 121 facing the heat exchange tube 1221 can be in a welding connection. For example, the surface of the heat exchange tube 1221 facing the heat dissipation plate 121 and the surface of the heat dissipation plate 121 facing the heat exchange tube 1221 are in a welding connection by means of brazing. In respect of the brazing, the deformation is small, and the welding area is flat and beautiful. Moreover, the brazing is conducive to ensuring that the surface of the heat exchange tube 1221 facing the heat dissipation plate 121 is in close contact with the surface of the heat dissipation plate 121 facing the heat exchange tube 1221, thereby not only improving the heat transfer effect between the heat dissipation plate 121 and the heat exchange tube 1221, but also having no need to provide other connection structures, which is beneficial to save space.

As shown in FIG. 20, a first end of the heat exchange tube 1221 is communicated to the refrigerant inlet pipeline 1222, and a second end of the heat exchange tube 1221 is communicated to the refrigerant outlet pipeline 1223. The refrigerant can enter the heat exchange tube 1221 through the refrigerant inlet pipeline 1222, and after exchanging heat with the heat dissipation plate 121 through the heat exchange tube 1221, it flows out through the refrigerant outlet pipeline 1223 and heat is carried away. This is conducive to ensuring the fluidity of the refrigerant inside the heat exchange tube 1221, and thus it is beneficial to ensure the heat dissipation efficiency and heat dissipation effect of the heat dissipation component 120.

An embodiment of the present disclosure further provides an air conditioner, which can be a central air conditioner or a common household air conditioner. The air conditioner includes a cabinet body and the electric control box 100 as described in the embodiments of the present disclosure. The electric control box 100 is mounted to the cabinet body, and for example, the electric control box can be mounted inside or outside the cabinet body. In a specific application, the electric control box 100 can control an operation of the air conditioner.

Due to the fact that the air conditioner of the embodiments of the present disclosure includes the electric control box 100 mentioned in the embodiments of the present disclosure, the beneficial effects of the electric control box 100 mentioned in the embodiments of the present disclosure are also possessed by the air conditioner of the embodiments of the present disclosure, and details will not be repeated here.

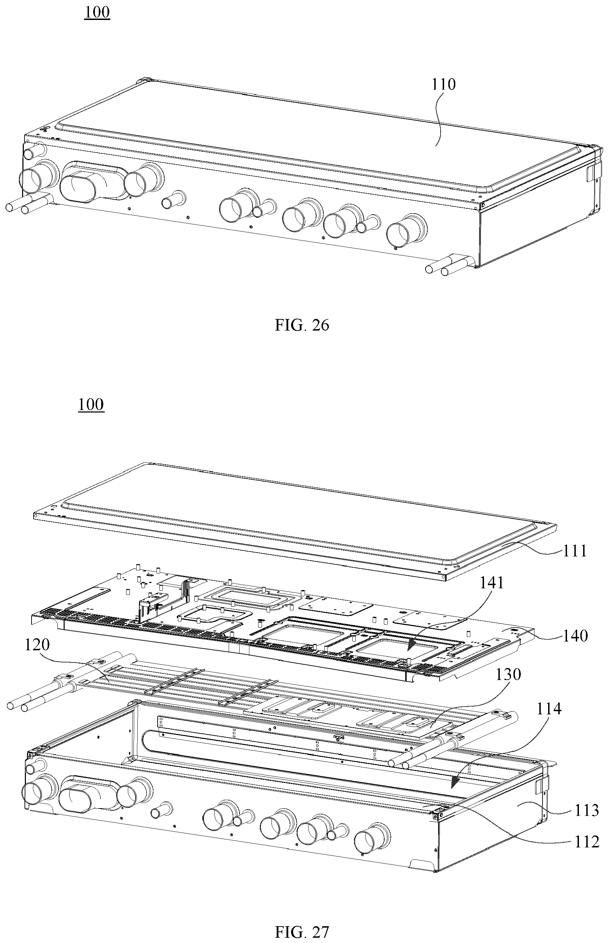

FIG. 26 is a structural schematic diagram of the electric control box of the present embodiment of the present disclosure; FIG. 27 is an exploded structural diagram of the electric control box in the embodiment of the present disclosure. As shown in FIGs. 26 and 27, the electric control box 100 can include a box body 110, where the box body 110 can include a bottom wall 112, a side wall 113, and a box cover 111. The side wall 113 is arranged around the bottom wall 112 in a circumferential direction of the bottom wall 112, and the box cover 111 is closed at an end of the side wall 113 away from the bottom wall 112, so that an accommodation cavity 114 is enclosed by the bottom wall 112, the side wall 113 and the box cover 114 together.

The electric control box of the embodiments of the present disclosure can be a sealed electric control box, for example. This can prevent water droplets, dust, and other foreign objects from entering the electric control box to cause damage to the electronic element inside the electric control box, and thus achieving waterproof, dustproof, and anti-corrosion effects.

The heat exchanger in the present disclosure can be a microchannel heat exchanger (heat exchange tube 120). The microchannel heat exchanger includes at least two sets of microchannels. The at least two sets of microchannels include multiple first microchannels for flowing a first refrigerant stream and multiple second microchannels for flowing a second refrigerant stream. The second refrigerant stream absorbs heat from the first refrigerant stream to render undercooling of the first refrigerant stream, or the first refrigerant stream absorbs heat from the second refrigerant stream to render undercooling of the second refrigerant stream.

The microchannel heat exchanger of the embodiments of the present disclosure can also serve as an economizer for an air conditioner. In this way, the microchannel heat exchanger not only can be used to cool an electronic element inside the electric control box, but also serves as the economizer, thereby avoiding a need to additionally provide an economizer outside the electric control box to simplify the structure of the air conditioner, save space and costs.

The electric control box 100 can further include a heat exchange tube 120, a heat dissipation plate 130, and an installation plate 140. The heat exchange tube 120, the heat dissipation plate 130, and the installation plate 140 are all accommodated in the accommodation cavity 114 of the box body 110. As an example, the heat exchange tube 120 can be mounted in the accommodation cavity of the box body 110 on a side close to the bottom wall 112. The heat dissipation plate 130 is stacked on a side of the heat exchange tube 120 facing away from the bottom wall 112, and the installation plate 140 is stacked on a side of the heat dissipation plate 130 facing away from the heat exchange tube 120. The surface of the installation plate 140 facing away from the heat dissipation plate 130 is mounted with an element to be heat dissipated (not shown in the drawing). The element to be heat dissipated can include a press, a fan or other electrical components that generate heat during operation.

It can be understood that an installation sequence of the heat exchange tube 120, the heat dissipation plate 130, and the installation plate 140 in the accommodation cavity 114 of the box body 110 can also be adjusted according to an actual need. For example, the heat exchange tube 120, the heat dissipation plate 130, and the installation plate 140 can be arranged in layers sequentially in a direction pointing from the box cover 111 to the bottom wall 112.

In addition, the accommodation cavity 114 of the box body 110 can further be provided with a circuit board (not shown in the drawing), a connection cable (not shown in the drawing), and other components that support the electronic control function of the electric control box 100. The side wall 113 of the box body 110 can be provided with a through hole, and a connection cable inside the accommodation cavity 114 of the box body 110 can be led out to the outside of the box body 110 through the through hole; an inlet pipeline and outlet pipeline of the heat dissipation tube inside the accommodation cavity 114 of the box body 110 can also be led out to the outside of the box body 110 through the through hole.

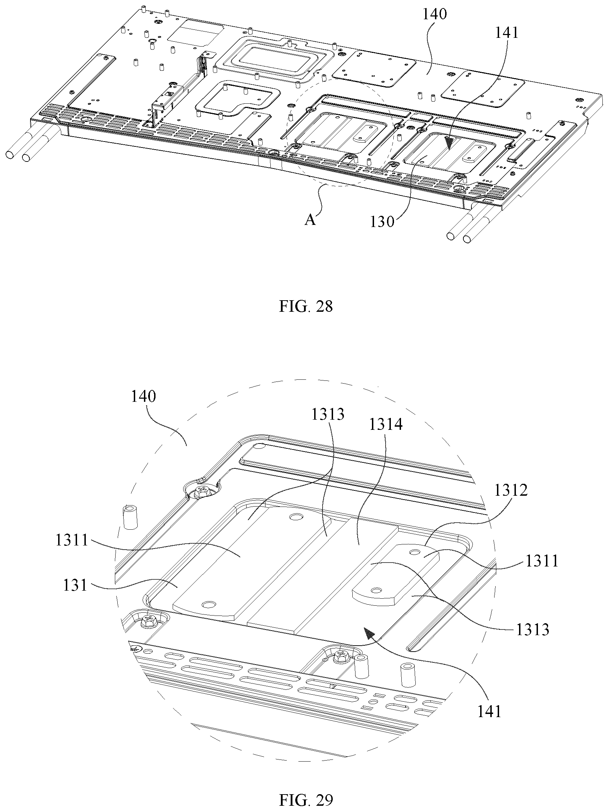

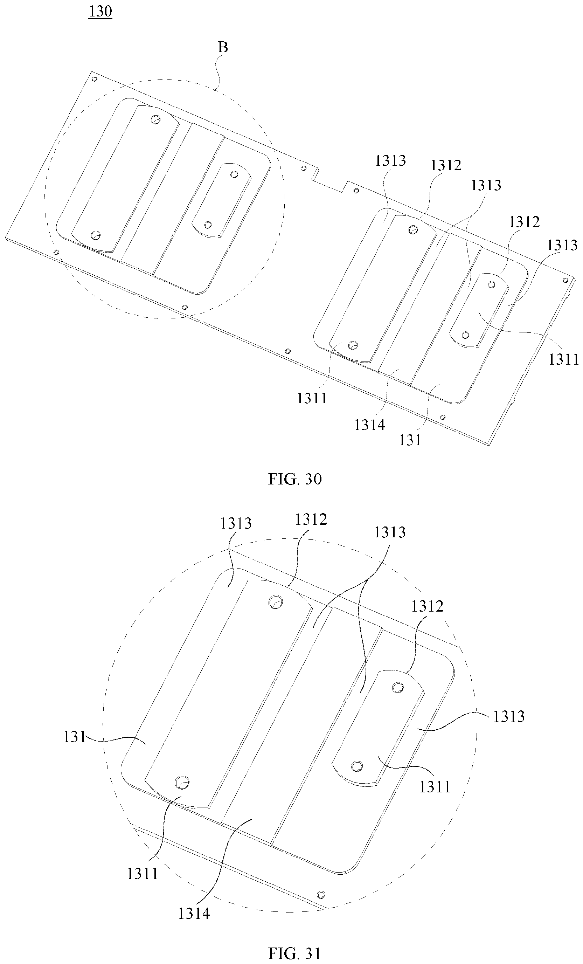

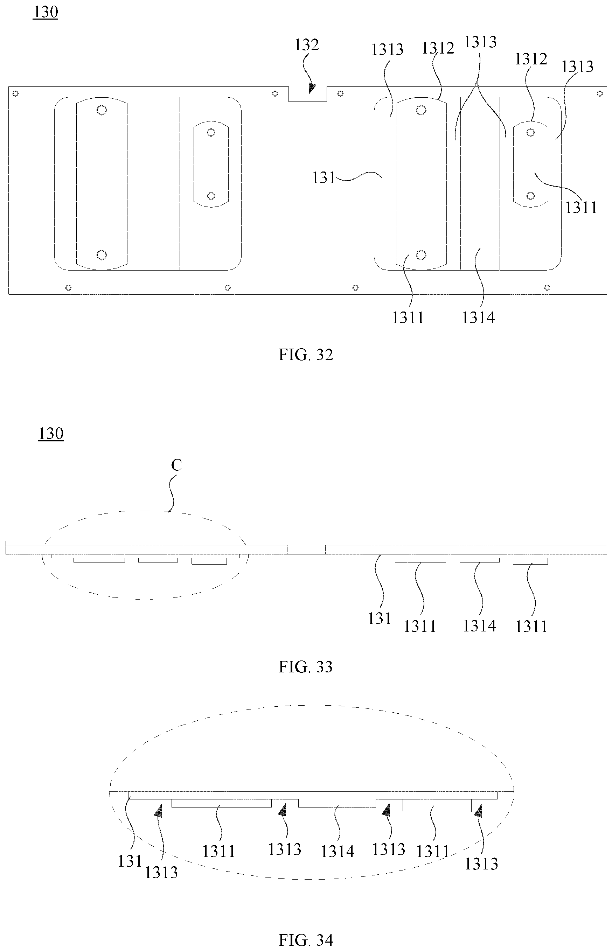

FIG. 28 is a structural schematic diagram of the heat dissipation plate being assembled with an installation plate in an embodiment of the present disclosure; FIG. 29 is a structural schematic diagram of the heat dissipation boss plate of the heat dissipation plate extending into an avoidance hole of the installation plate in an embodiment of the present disclosure; FIG. 30 is a structural schematic diagram of the heat dissipation plate of the embodiment of the present disclosure; FIG. 31 is a schematic diagram of a local structure with the heat dissipation plate being provided with a heat dissipation boss plate according to the embodiment of the present disclosure; FIG. 32 is a front view of the heat dissipation plate of the embodiment of the present disclosure; FIG. 33 is a top view of the heat dissipation plate of the embodiment of the present disclosure; FIG. 34 is a local top view with the heat dissipation plate being provided with the heat dissipation boss plate according to the embodiment of the present disclosure.

As shown in FIGs. 28 to 34, a side of the heat dissipation plate 130 facing the installation plate 140 is provided with a heat dissipation boss plate 1311. A position of the installation plate 140 corresponding to the heat dissipation boss plate 1311 is provided with an avoidance hole 141; the heat dissipation boss plate 1311 can penetrate through the avoidance hole 141 and come into contact with the element to be heat dissipated, so that the heat dissipation plate 130 can directly effectuate heat dissipation for the element to be heat dissipated, which is conducive to improving the heat dissipation efficiency and improving the heat dissipation effect.

For example, a surface of the heat dissipation boss plate 1311 contacting with the element to be heat dissipated is a top surface of the heat dissipation boss plate 1311, and the surface of the element to be heat dissipated contacting with the heat dissipation boss plate 1311 is a bottom surface of the element to be heat dissipated. When the bottom surface of the element to be heat dissipated is a plane, the top surface of the heat dissipation boss plate 1311 can be set as a plane; when the bottom surface of the element to be heat dissipated is concave, the top surface of the heat dissipation boss plate 1311 can be set as a convex surface that matches the concave surface at the bottom surface of the element to be heat dissipated; when the bottom surface of the element to be heat dissipated is convex, the top surface of the heat dissipation boss plate 1311 can be arranged as a concave surface that matches the bottom surface of the element to be heat dissipated, to ensure that the top surface of the heat dissipation boss plate 1311 closely fits the bottom surface of the element to be heat dissipated, thereby improving a thermal conductivity between the heat dissipation boss plate 1311 and the element to be heat dissipated.

Optionally, thermal conductive silicone grease can be applied between the top surface of the heat dissipation boss plate 1311 and the bottom surface of the element to be heat dissipated, to further improve the thermal conductivity between the heat dissipation boss plate 1311 and the element to be heat dissipated, which is beneficial for further improving the heat dissipation efficiency and heat dissipation effect of the heat dissipation plate 130.

The shape and size of the top surface of the heat dissipation boss plate 1311 can be set according to the shape and size of the bottom surface of the element to be heat dissipated. In a possible implementation mode of the embodiment of the present disclosure, the shape and size of the top surface of the heat dissipation boss plate 1311 can be the same as the shape and size of the bottom surface of the element to be heat dissipated, to maximize the contact area between the top surface of the heat dissipation boss plate 1311 and the bottom surface of the element to be heat dissipated, and thereby further improving the thermal conductivity between the heat dissipation boss plate 1311 and the element to be heat dissipated.

In other possible implementation modes of the embodiment of the present disclosure, a projection of the top surface of the heat dissipation boss plate 1311 on the installation plate 140 can also be set to fall within a projection range of the bottom surface of the ready-for-heat-dissipation element on the installation plate 140 according to an actual need; or, the projection of the bottom surface of the ready-for-heat-dissipation element on the installation plate 140 can be set to fall within the projection range of the top surface of the heat dissipation boss plate 1311 on the installation plate 140 according to an actual need.

In a specific implementation, the heat dissipation plate 130 and the installation plate 140 are assembled together, and the heat dissipation boss plate 1311 on the heat dissipation plate 130 penetrates through the avoidance hole 141 on the installation plate 140 and extends to a side of the installation plate 140 for installing the element to be heat dissipated. Some elements to be heat dissipated, such as a presser and a fan, can be mounted on the heat dissipation boss plate 1311, so that the heat dissipation boss plate 1311 can directly contact the element to be heat dissipated. Thus, through the heat dissipation boss plate 1311, the heat dissipation plate 130 can directly cool the element to be heat dissipated, which is conducive to improving the heat dissipation efficiency of the heat dissipation plate 130, improving the heat dissipation effect of the heat dissipation plate 130, and avoiding a problem that the temperature rises due to heat accumulation inside the electric control box 100 and, in turn, the electric control box 100 cannot work normally.

The electric control box 100 provided in the embodiments of the present disclosure involves arranging the heat dissipation plate 130 and the installation plate 140 inside the electric control box 100 in layers, and providing a ready-for-heat-dissipation on the side of the installation plate 140 facing away from the heat dissipation plate 130, so that the heat dissipation plate 130 can effectuate heat dissipation for the ready-for-heat-dissipation element provided on the installation plate 140. At the same time, by providing a heat dissipation boss plate 1311 on a side of the heat dissipation plate 130 facing the installation plate 140, and providing an avoidance hole 141 at a position of the installation plate 140 corresponding to the heat dissipation boss plate 1311, so that the heat dissipation boss plate 1311 can penetrate through the avoidance hole 141 and come into contact with the element to be heat dissipated, thereby the heat dissipation plate 130 can better cool the element to be heat dissipated, which is conducive to improving the heat dissipation effect of the heat dissipation plate 130 inside the electric control box 100.

As shown in FIGs. 30, 31, 33, and 34, a limit boss plate 131 can be provided on the heat dissipation plate 130, the limit boss plate 131 faces a side of the installation plate 140. The limit boss plate 131 can extend into the avoidance hole 141, and the shape of the limit boss plate 131 matches the shape of the avoidance hole 141. It can be understood that the shape of the limit boss plate 131 matching the shape of the avoidance hole 141 means that the shape of the limit boss plate 131 is the same as the shape of the avoidance hole 141, and the limit boss plate 131 can extend into the avoidance hole 141 and a circumferential edge of the limit boss plate 131 is allowed to come into contact with a circumferential edge of the avoidance hole 141, so as to achieve a mutual positioning between the limit boss plate 131 and the avoidance hole 141, thereby stabilizing a relative position between the installation plate 140 and the heat dissipation plate 130, avoiding a shaking of the heat dissipation plate 130 relative to the installation plate 140, and thereby improving the heat dissipation effect of the heat dissipation plate 130.

The heat dissipation boss plate 1311 can be provided on the limit boss plate 131. After the relative position between the limit boss plate 131 and the avoidance hole 141 is stabilized, the relative position between the heat dissipation boss plate 1311 and the installation plate 140 can be determined, which is conducive to ensuring the relative stability between the element to be heat dissipated and the heat dissipation boss plate 1311, and thus ensuring that the top surface of the heat dissipation boss plate 1311 is in contact with the bottom surface of the element to be heat dissipated, so as to ensure a thermal conductivity between the element to be heat dissipated and the heat dissipation boss plate 1311, and improve the heat dissipation effect.

It can be understood that the side of the heat exchange tube 120 facing away from the installation plate 140 is provided with a heat exchange tube 120. The heat exchange tube 120 can take away heat on the heat dissipation plate 130, which renders the temperature of the heat dissipation plate 130 to be relatively low. When the air inside the box body 110 come into contact with the heat dissipation plate 130 having a relatively low temperature, condensate water will form on a surface of the heat dissipation plate 130. A contact between the condensate water and the ready-for-heat-dissipation element on the installation plate 140 will affect the performance of the ready-for-heat-dissipation element, and even cause damage to the ready-for-heat-dissipation element.

In order to solve a problem that condensate water accumulating on the heat dissipation plate 130 affects the performance of the element to be heat dissipated, a discharge structure can be provided around the heat dissipation boss plate 1311 in the electric control box 100 provided in the embodiment of the present disclosure, so that the condensate water accumulated on the heat dissipation plate 130 can be discharged under the guide of the discharge structure, thereby avoiding excessive condensate water accumulated on the heat dissipation plate 130 from contacting the element to be heat dissipated, and thereby ensuring the performance of the element to be heat dissipated, which is beneficial to ensure a normal operation of the electric control box 100.

As shown in FIGs. 30 to 32, the discharge structure can include a drainage surface 1312; water that flows to the drainage surface 1312 can be discharged out of the heat dissipation boss plate 1311 under the guide of the drainage surface 1312. For example, the drainage surface 1312 can be formed on an end face of the heat dissipation boss plate 1311 facing a water flow direction. When the condensate water converges and flows to the end face of the heat dissipation boss plate 1311 facing the water flow direction, the drainage surface 1312 can drain the condensate water and render the condensate water to be smoothly discharged, thereby preventing the condensate water from gathering and spreading to a top surface of the heat dissipation boss plate 1311 at an end of heat dissipation boss plate 1311 facing the water flow direction. It can be understood that the water flow direction usually refers to a direction in which water flows from high to low under an action of gravity. Therefore, the end face of the heat dissipation boss plate 1311 facing the water flow direction is related to an installation direction of the heat dissipation plate 130 inside the electric control box 100 and an installation direction of the electric control box 100.

For example, after the installation of the electric control box 100 is completed, if a first end of the heat dissipation boss plate 1311 is higher than a second end of the heat dissipation boss plate 1311, the first end of the heat dissipation boss plate 1311 is an end thereof facing the water flow direction. At this time, the drainage surface 1312 can be arranged at the first end of the heat dissipation boss plate 1311. Alternatively, after the installation of the electric control box 100 is completed, if the second end of the heat dissipation boss plate 1311 is higher than the first end of the heat dissipation boss plate 1311, the second end of the heat dissipation boss plate 1311 is the end facing the water flow direction. At this time, the drainage surface 1312 can be arranged at the second end of the heat dissipation boss plate 1311. In order to increase the flexibility of the heat dissipation plate 130 during installation and use, drainage surfaces 1312 can be provided at both ends of the heat dissipation boss plate 1311 of the heat dissipation plate 130. This not only allows the installation position of the heat dissipation plate 130 to be changed according to an actual need, but also allows the installation position of the electric control box 100 to be changed according to actual needs; and thus, ensuring that the condensate water on the heat dissipation plate 130 can be discharged smoothly.

As shown in FIGs. 30 to 32, a middle of the drainage surface 1312 protrudes from both ends of the drainage surface. For example, the drainage surface 1312 gradually decreases from the middle to both ends, which allows the drainage surface 1312, when encountering a stream of condensate water flowing down, to guide the condensate water to flow towards both ends of the drainage surface 1312 and finally be discharged. This can prevent the condensate water from gathering around the heat dissipation boss plate 1311 and coming into contact with the ready-for-heat-dissipation element arranged on the top surface of the heat dissipation boss plate 1311, it is beneficial for protecting the performance of the ready-for-heat-dissipation element.

In one implementation mode of the embodiments of the present disclosure, the drainage surface 1312 can be an arc-shaped surface, where a middle of the arc-shaped surface bents toward the water flow direction, so that the condensate water that flows to the end face of the heat dissipation boss plate 1311 facing the water flow direction can flow to both sides of the arc-shaped surface and finally be discharged.

In another implementation mode of the embodiment of the present disclosure, the drainage surface 1312 is a folded surface, where a middle of the folded surface bends facing the water flow direction. For example, the folded surface may include a V-shaped surface formed by two planes sinking and extending from the middle to both sides; it can also include multiple planes that are sunk and spliced from the middle to both sides, as long as the shape of the folded surface can meet the requirements of bending in the middle facing the water flow direction, so that the condensate water can flow toward both sides.

As shown in FIGs. 29 to 32, the heat dissipation boss plate 1311 can be an elongated block, where a long side of the elongated block is consistent with the water flow direction. Two short sides of the elongated block are arranged on a side facing the water flow direction and the side towards the water flow direction, respectively. End faces on the short sides of the elongated block form the drainage surfaces 1312. It can be understood that the drainage surface 1312 is formed by the end faces of the elongated block facing the water flow direction. Of course, in order to improve the installation flexibility of the heat dissipation plate 130, the end faces on the two opposite short sides of the heat dissipation plate 130 can both form the drainage surfaces 1312, so that after changing the installation direction of the heat dissipation plate 130, the discharge on the heat dissipation plate 130 will not be affected.

As shown in FIGs. 28 to 34, the discharge structure can also include a discharge grooves 1313, which are respectively arranged on both sides of the heat dissipation boss plate 1311. For example, both sides of the heat dissipation boss plate 1311 may be provided with a discharge groove 1313, respectively; and the discharge grooves 1313 on both sides of the heat dissipation boss plate 1311 can discharge the water flowing from the drainage surface 1312 from an area of the heat dissipation plate 130 corresponding to the avoidance hole 141. When a limit boss plate 131 is provided on the heat dissipation plate 130, and the limit boss plate 131 is matched with the avoidance hole 141, both the discharge groove 1313 and the heat dissipation boss plate 1311 can be provided on the limit boss plate 131. At this time, the discharge groove 1311 can discharge the water led by the drainage surface 1312 from the limit boss plate 131.

For example, two side walls 113 of the heat dissipation boss plate 1311 can be formed as groove walls of the discharge groove 1313 arranged on both sides of the heat dissipation boss plate 1311, and the end face of the heat dissipation boss plate 1311 facing the water flow direction can be formed as the drainage surface 1312. At this time, the two sides of the end face of the heat dissipation boss plate 1311 facing the water flow direction are connected to the two side walls 113 of the heat dissipation boss plate 1311 to form a discharge structure around the heat dissipation boss plate 1311. This not only facilitates the discharge of condensate water around the heat dissipation boss plate 1311, but also helps to protect the element to be heat dissipated, and does not require additional processing of the side surface of the discharge groove 1313, which simplifies the structure of the heat dissipation plate 130. For example, the bottom of the discharge groove 1313 can be a flat surface, a concave V-shaped surface, or a concave curved surface, which is conducive to accelerating the accumulation and discharge of the condensate water.

In a specific application, when the condensate water on the heat dissipation plate 130 flows to the end face of the heat dissipation boss plate 1311 facing the water flow direction, the drainage surface 1312 can divert the condensate water to both sides of the drainage surface 1312 to allow the condensate water to flow into the discharge groove 1313. The discharge groove 1313 then draws the condensate water downwards to discharge the condensate water, thereby preventing an excessive accumulation of condensate water from contacting with the element to be heat dissipated.

The two ends of the discharge groove 1313 along the water flow direction can both extend to the edge of the limit boss plate 131, so that the condensate water on the heat dissipation plate 130 can enter the discharge groove 1313 through one end of the discharge groove 1313 facing the water flow direction, and then flow to the other end of the discharge groove 1313 towards the water flow direction under the guide of the discharge groove 1313, thereby enabling the condensate water to be quickly and thoroughly discharged. At the same time, the installation position of the heat dissipation plate 130 can be changed according to actual needs, without affecting the discharge of the condensate water.

As shown in FIGs. 33 and 34, a bottom of the discharge groove 1313 is higher than a plane surface where the bottom end of the limit boss plate 131 is arranged, and the bottom of the discharge groove 1313 is lower than the top surface of the heat dissipation boss plate 1311. On the one hand, it is possible to prevent condensate water, at other positions except for the limit boss plate 131 on the heat dissipation plate 130, from entering the discharge groove 1313 on the limit boss plate 131; on the other hand, it is possible to prevent excessive accumulation of water flow in the discharge groove 1313 from spreading to the top surface of the heat dissipation boss plate 1311, which is beneficial for protecting the element to be heat dissipated from being influenced by the condensate water.

As shown in FIGs. 29 and 32, the limit boss plate 131 can be provided with at least two heat dissipation boss plates 1311; the at least two heat dissipation boss plates 1311 are arranged to be spaced apart in a direction perpendicular to an extension direction of the discharge groove, which is not only conducive to increasing the number of elements to be heat dissipated that can be directly contacted with and cooled by the heat dissipation boss plate 1311, but also to improving the heat dissipation effect of the heat dissipation plate 130; and the arrangement of two heat dissipation boss plates 1311 will not affect the flow and discharge of the condensate water. As an example, the at least two heat dissipation boss plates 1311 may have a same shape or different shapes, and a same height or different heights.

A block 1314 can be provided between two adjacent heat dissipation boss plates 1311; the block 1314 can extend along the water flow direction to an edge of the limit boss plate 131; the discharge groove 1313 is formed between the side surface of the block 1314 along the water flow direction and the heat dissipation boss plate 1311 which is arranged at this side. For example, the side wall 113 of the heat dissipation boss plate 1311 close to the block 1314 and the side wall 113 of the block 1314 close to the heat dissipation boss plate 1311 jointly define a range of the discharge groove 1313, which not only facilitates the discharge of the condensate water, but also helps to reduce a distance between the heat dissipation plate 130 and the element to be heat dissipated, or increase a contact area between the heat dissipation plate 130 and the element to be heat dissipated; and thereby beneficial to improving the heat dissipation efficiency.

As shown in FIGs. 33 and 34, a top surface of the block 1314 is lower than a top surface of the lowest one of at least two heat dissipation boss plates 1311, or the top surface of the block 1314 is flush with the top surface of the lowest one of at least two heat dissipation boss plates 1311. Thus, it is beneficial to prevent the block 1314 from interfering with the ready-for-heat-dissipation element mounted on the heat dissipation boss plate 1311. Moreover, a distance between the top surface of the block 1314 and the bottom surface of the element to be heat dissipated is relatively small or the top surface of the block 1314 is in direct contact with the bottom surface of the element to be heat dissipated, which can further improve the heat dissipation effect of the heat dissipation plate 130 to the element to be heat dissipated.

As shown in FIG. 28, at least two limit boss plates 131 can be provided on a side of the heat dissipation plate 130 facing the installation plate 140; the at least two limit boss plates 131 can be arranged to be spaced apart along a direction perpendicular to the water flow direction, so as not to hinder the discharge of condensate water from other positions of the heat dissipation plate 130. At least two avoidance holes 141 are arranged on the installation plate 140, and at least two limit boss plates 131 extend into at least two avoidance holes 141 one by one. On the one hand, the number of avoidance holes matching the limit boss plate can be increased to increase the number of heat dissipation boss plates 1311, thereby increasing the number of the electronic element to be heat dissipated that are directly in contact with and cooled by the heat dissipation boss plate, which is conducive to improving the heat dissipation efficiency and heat dissipation effect of the heat dissipation plate 130. On the other hand, the stability of fitting between the heat dissipation plate 130 and the installation plate 140 can be further improved.

As shown in FIGs. 30 to 32, an edge of the heat dissipation plate 130 can be provided with a positioning notch 132, and the positioning notch 132 can position an installation position of the heat dissipation plate 130. For example, the positioning notch 132 can be set at one edge of the heat dissipation plate 130 facing the water flow direction, or on the other edge of the heat dissipation plate 130 towards the water flow direction, or on both sides of the heat dissipation plate 130 parallel to the water flow direction. The number of positioning notches 132 can be set to one, two, or more according to actual needs. When the number of positioning notches 132 is two or more, the positioning notches 132 can be arranged to be spaced apart only at one edge of the heat dissipation plate 130, or can be simultaneously arranged on at least two edges of the heat dissipation plate 130. The shape of the positioning notch 132 can be rectangular, semi-circular, triangular, or other shapes that meet the positioning requirements.

During an installation of the heat dissipation plate 130 on the heat exchange tube 120, the positioning notch 132 of the heat dissipation plate 130 can be clamped with a positioning structure on the heat exchange tube 120 to achieve pre-positioning of the installation of the heat dissipation plate 130, which is beneficial to improve the installation efficiency.

The embodiment of the present disclosure further provides an air conditioner, which can be a central air conditioner or a common household air conditioner. The air conditioner includes a cabinet body and the electric control box 100 as described in the embodiments of the present disclosure. The electric control box 100 is mounted to the cabinet body, and for example, the electric control box can be mounted inside or outside the cabinet body. In a specific application, the electric control box 100 can control an operation of the air conditioner.

Due to the fact that the air conditioner of this embodiment includes the electric control box 100 mentioned in the embodiments of the present disclosure, the beneficial effects of the electric control box 100 mentioned in the embodiments of the present disclosure are also possessed by the air conditioner of this embodiment, and details will not be repeated here.

In the description of the present disclosure, it should be understood that terms "middle", "longitudinal", "horizontal", "length", "width", "thickness", "up", "down", "front", "back", "left", "right", "vertical", "plane", "top", "bottom", "inside", "outside", "clockwise", "counterclockwise", "axial", "radial", and "circumferential" and the like indicating an orientation or positional relationship is based on the orientation or positional relationship shown in the drawings, and is only for the convenience of describing and simplifying the present disclosure, rather than indicating or implying that the device or component referred to must have a specific orientation, be constructed and operated in a specific orientation, and therefore cannot be understood as a limitation of the present disclosure.

In addition, terms "first" and "second" are only used to describe the purpose and cannot be understood as indicating or implying relative importance or implying the quantity of technical features indicated. Therefore, features defined by "first" and "second" can explicitly or implicitly include at least one of these features. In the description of the present disclosure, unless otherwise specifically defined, "multiple" means at least two, such as two, three, etc.

In the present disclosure, unless otherwise specified and limited, terms "installation", "connection with", "connection to", "fixing" and other terms should be understood broadly, for example, it can be a fixed connection, a detachable connection, or an integrated connection; it can be a mechanical connection or an electrical connection; it can be a direct connection or an indirect connection through an intermediate medium, which can be an internal connection between two components or an interaction relationship between two components, unless otherwise specified. For ordinary technical personnel in this field, the specific meanings of the above terms in the present disclosure can be understood based on specific circumstances.

In the present disclosure, unless otherwise specified and limited, a first feature may be in direct contact with a second feature that is "above" or "below" the first feature, or the first and second features may be in indirect contact through an intermediate media. Moreover, the first feature being "above", "up", and "on" the second feature is that the first feature is directly or diagonally above the second feature, or simply indicates that the first feature is horizontally higher than the second feature. The first feature being "below", "under" and "beneath" the second feature is that the first feature is directly or diagonally below the second feature, or simply indicates that a horizontal height of the first feature is less than that of the second feature.

In the description of the present specification, reference terms "one embodiment", "some embodiments", "examples", "specific examples", or "some examples" refer to the specific features, structures, materials, or features described in combination with the embodiment or example being included in at least one embodiment or example of the present disclosure. In this specification, the schematic expressions of the above terms do not necessarily refer to the same embodiments or examples. Moreover, the specific features, structures, materials, or features described can be combined in an appropriate manner in any one or more embodiments or examples. In addition, those skilled in the art may corporate and combine the different embodiments or examples described in this specification, as well as the features of different embodiments or examples, without mutual contradiction.

Although embodiments of the present disclosure have been shown and described above, it can be understood that the above embodiments are exemplary and cannot be understood as limitations to the present disclosure. Ordinary technical personnel in the art may make changes, modifications, substitutions, and variations to the above embodiments within the scope of the present disclosure.

## Claims

1. A heat dissipation plate for an electric control box, comprising a heat dissipation plate body, wherein the heat dissipation plate body is provided with at least two heat dissipation boss plates spaced apart; wherein an accommodation area is defined between at least two adjacently arranged heat dissipation boss plates, and the accommodation area is provided with a temperature-and-humidity sensor.

2. The heat dissipation plate for the electric control box according to claim 1, wherein the heat dissipation boss plate has a drainage surface configured to discharge water that flows to the drainage surface out of the heat dissipation boss plate.

3. The heat dissipation plate for the electric control box according to claim 2, wherein the temperature-and-humidity sensor is arranged away from drainage surfaces of the two adjacent heat dissipation boss plates in the accommodation area.

4. The heat dissipation plate for the electric control box according to claim 2, wherein the temperature-and-humidity sensor is arranged close to the drainage surface of any one of the two adjacent heat dissipation boss plates in the accommodation area.

5. The heat dissipation plate for the electric control box according to claim 3, wherein a drainage groove is formed in the accommodation area, and the drainage surfaces of the two adjacent heat dissipation boss plates are connected to a first end of the drainage groove, a second end of the drainage groove extends in a direction away from the drainage surfaces; and the drainage groove is configured to discharge water on the drainage surfaces from the heat dissipation boss plates.

6. The heat dissipation plate for the electric control box according to claim 5, wherein the accommodation area is provided with a block, and the drainage groove is formed between the block and an adjacent heat dissipation boss plate.

7. The heat dissipation plate for the electric control box according to claim 6, wherein the temperature-and-humidity sensor is arranged in the drainage groove and is arranged close to the second end of the drainage groove.

8. The heat dissipation plate for the electric control box according to any one of claims 2 to 7, wherein the drainage surface is arranged at an edge of the heat dissipation boss plate away from a surface of the heat dissipation plate body.

9. The heat dissipation plate for the electric control box according to any one of claims 1 to 7, wherein the heat dissipation plate body is provided with at least one limit boss plate, and both the limit boss plate and the heat dissipation boss plate are arranged on a same plate surface of the heat dissipation plate body; and the limit boss plate is arranged between the heat dissipation plate body and the heat dissipation boss plate.

10. The heat dissipation plate for the electric control box according to claim 9, wherein there are multiple limit boss plates, and the multiple limit boss plates are arranged to be spaced apart on the heat dissipation plate body.

11. The heat dissipation plate for the electric control box according to claim 10, wherein at least one of the multiple limit boss plates is provided with the at least two heat dissipation boss plates; the at least two heat dissipation boss plates are arranged to be spaced apart on a same limit boss plate; and the accommodation area is defined between two adjacently arranged heat dissipation boss plates on the same limit boss plate.

12. The heat dissipation plate for the electric control box according to any one of claims 1 to 7, wherein a detection end of the temperature-and-humidity sensor is no higher than a surface of the heat dissipation boss plate facing away from the heat dissipation plate body.

13. A heat dissipation component, comprising a heat exchanger and the heat dissipation plate for the electric control box according to any one of claims 1 to 12, wherein the heat exchanger is arranged on a side of the heat dissipation plate away from the heat dissipation boss plate.

14. The heat dissipation component according to claim 13, wherein the heat exchanger is adhered to a surface of the heat dissipation plate away from the side of the heat dissipation boss plate; and a projection of the heat exchanger on the heat dissipation plate coincides at least partially with the temperature-and-humidity sensor of the heat dissipation plate.

15. An electric control box, comprising an installation plate for installing an electronic element and the heat dissipation component according to claim 13 or 14, wherein the installation plate and the heat dissipation plate of the heat dissipation component are arranged in layers; and the heat exchanger of the heat dissipation component is arranged on a side of the heat dissipation plate away from the installation plate.

16. The electric control box according to claim 15, wherein the installation plate is provided with a limit notch, the limit notch is arranged to be opposite to the limit boss plate of the heat dissipation plate, and the limit boss plate penetrates through the limit notch; and the temperature-and-humidity sensor on the heat dissipation plate is arranged in the limit notch.

17. The electric control box according to claim 15 or 16, wherein the electric control box is a sealed electric control box.

18. An air conditioner, comprising a main device and the electric control box according to any one of claims 15 to 17, wherein the electric control box is mounted on the main device.

19. A heat dissipation plate component, comprising a connector and the heat dissipation plate for the electric control box according to any one of claims 1 to 12, wherein the heat dissipation plate is provided with a connection hole, the connector is embedded in the connection hole, and a hardness of the connector is greater than a hardness of the heat dissipation plate; and the connector has a threaded installation hole, and an axial direction of the threaded installation hole is consistent with an axial direction of the connection hole, and the connector is configured to be connected to a retaining plate through the threaded installation hole.

20. The heat dissipation plate component according to claim 19, wherein the connector is press-fitted into the connection hole, and a side wall of the connector is closely fitted with a wall of the connection hole.

21. The heat dissipation plate component according to claim 19 or 20, wherein the connector has a first end face and a second end face that are arranged to be opposite in an axial direction of the connector, the first end face is flush with a plate surface of the heat dissipation plate, and the second end face is arranged in the connection hole.

22. The heat dissipation plate component according to claim 21, wherein a maximum radial length of the first end face in a radial direction of the threaded installation hole is greater than a maximum radial length of the second end face in the radial direction of the threaded installation hole.

23. The heat dissipation plate component according to claim 22, wherein the connector comprises multiple anti-rotation units that are sequentially connected along the axial direction of the threaded installation hole, projection surfaces of the anti-rotation units in the axial direction of the connection hole are non-circular surfaces, and maximum radial lengths of the multiple anti-rotation units in the radial direction of the threaded installation hole gradually decrease in a direction from an end face of the connection hole to a bottom of the connection hole.

24. The heat dissipation plate component according to claim 23, wherein an anti-rotation unit comprises multiple anti-rotation parts distributed in a circumferential direction of the connector, and outer circumferential edges of the anti-rotation part are non-circular edges.

25. The heat dissipation plate component according to claim 24, wherein outer circumferential edge surfaces of the anti-rotation parts are flat surfaces, so that the projection surfaces of the anti-rotation units in the axial direction of the connection hole are polygonal.

26. The heat dissipation plate component according to any one of claims 23 to 25, wherein maximum radial edges of the projection surfaces of the anti-rotation units in the axial direction of the connection hole are each arranged on a same circumference, and the maximum radial edges of the projection surfaces of the individual anti-rotation units in the axial direction of the connection hole are arranged on circumferences that are equal.

27. The heat dissipation plate component according to claim 24 or 25, wherein the anti-rotation part has a guide surface facing a bottom end of the connection hole, the guide surface is arranged to be inclined relative to an axial direction of the connector, and an outer side of the guide surface is higher than an inner side of the guide surface.

28. The heat dissipation plate component according to claim 27, wherein the anti-rotation part further comprises a stop surface arranged on a side of the guide surface facing away from the bottom of the connection hole, and the stop surface extends along a radial direction of the connection hole.

29. The heat dissipation plate component according to claim 28, wherein the stop surface is parallel to the first end face.

30. The heat dissipation plate component according to any one of claims 23 to 25, wherein the connector further comprises a first support portion and a second support portion that are arranged to be opposite, the multiple anti-rotation units are connected between the first support portion and the second support portion, and an end of the first support portion facing away from the second support portion forms the first end face, and an end of the second support portion facing away from the first support portion forms the second end face.

31. The heat dissipation plate component according to claim 30, wherein an outer contour of the first end face is circular, and an outer contour of the second end face is polygonal.

32. The heat dissipation plate component according to claim 31, wherein the connector further comprises multiple connection parts, and the connection parts are arranged to correspond to the anti-rotation units one by one; and
the connection parts are connected between the first support portion and the anti-rotation units; and/or, the connection parts are connected between two adjacent anti-rotation units.

33. An electric control box, comprising a box body and the heat dissipation plate component according to any one of claims 19 to 32, wherein the heat dissipation plate component is arranged inside the box body.

34. The electric control box according to claim 33, wherein the heat dissipation plate component comprises a heat dissipation plate and a microchannel heat exchanger, wherein the microchannel heat exchanger is arranged at a bottom of the box body, and the heat dissipation plate is arranged on a side of the microchannel heat exchanger facing away from the bottom of the box body.

35. The electric control box according to claim 34, wherein the electric control box further comprises a retaining plate which is arranged inside the box body, and the retaining plate is arranged on a side of the heat dissipation plate facing away from the bottom of the box body.

36. The electric control box according to claim 35, wherein the box body comprises a box cover and a box main body with an opening, the box cover covers the opening of the box main body, the heat dissipation plate component is provided at a bottom of the box main body, the retaining plate is arranged on a side of the heat dissipation plate component facing the opening, and the retaining plate is connected to the connector of the heat dissipation plate component.

37. The electric control box according to any one of claims 33 to 36, wherein the electric control box is a sealed electric control box.

38. An outdoor air conditioning unit, comprising the electric control box according to any one of claims 33 to 37.

39. An air conditioner, comprising the outdoor air conditioning unit according to claim 38.

40. A heat dissipation component, comprising: a heat exchange tube component and the heat dissipation plate for the electric control box according to any one of claims 1 to 12; the heat dissipation plate and the heat exchange tube component are arranged in layers; and a surface of the heat dissipation plate facing the heat exchange tube component is in contact with a surface of the heat exchange tube component facing the heat dissipation plate; the surface of the heat dissipation plate facing the heat exchange tube component is provided with a limit rib; the limit rib extends along an extension direction of the heat exchange tube component; and a side surface of the limit rib facing the heat exchange tube component abuts against a side surface of the heat exchange tube component facing the limit rib; and the heat dissipation plate and the limit rib are an integrated part.

41. The heat dissipation component according to claim 39, wherein the heat dissipation plate and the limit rib are an integral part formed by an extrusion molding process.

42. The heat dissipation component according to claim 39, wherein a top of the limit rib is lower than a surface of the heat exchange tube component away from the heat dissipation plate, or the top of the limit rib is flush with the surface of the heat exchange tube component away from the heat dissipation plate.

43. The heat dissipation component according to claim 39, wherein the heat exchange tube component comprises one or more heat exchange tubes, the limit rib comprises at least two, and at least two limit ribs are arranged to be spaced apart; and at least one heat exchange tube is clamped between two adjacent limit ribs.

44. The heat dissipation component according to claim 39, wherein the heat exchange tube component comprises at least two heat exchange tubes; and in a plane parallel to the heat dissipation plate, the at least two heat exchange tubes are parallel to each other and arranged to be spaced apart.

45. The heat dissipation component according to claim 44, wherein a surface of the heat dissipation plate facing the heat exchange tube is provided with a groove, which extends along an extension direction of the heat exchange tube, and the groove is arranged between two adjacent heat exchange tubes.

46. The heat dissipation component according to claim 45, wherein a width of the groove is less than or equal to a width of a spacing between two adjacent heat exchange tubes.

47. The heat dissipation component according to claim 45, wherein a depth of the groove is less than or equal to 1/2 of a thickness of the heat dissipation plate.

48. The heat dissipation component according to any one of claims 39 to 47, wherein the heat exchange tube is a microchannel flat tube, and a flat surface of the microchannel flat tube is in contact with the heat dissipation plate.

49. The heat dissipation component according to any one of claims 39 to 47, wherein a surface of the heat dissipation plate facing the heat exchange tube is in a welding connection to a surface of the heat exchange tube facing the heat dissipation plate.

50. An electric control box, comprising a box body and the heat dissipation component according to any one of claims 39 to 49, wherein the heat dissipation component is arranged in the box body.

51. The electric control box according to claim 50, wherein the electric control box is a sealed electric control box, and the heat exchange tube component is at least partially arranged inside the electric control box.

52. An air conditioner, comprising a cabinet body and the electric control box according to claim 50 or 51, wherein the electric control box is mounted to the cabinet body.

53. An electric control box, comprising an installation plate and the heat dissipation plate for the electric control box according to any one of claims 1 to 12; the heat dissipation plate and the installation plate are arranged in layers, and a side of the installation plate facing away from the heat dissipation plate is provided with an element to be heat dissipated; and a side of the heat dissipation plate facing the installation plate is provided with a heat dissipation boss plate, and an area of the installation plate corresponding to the heat dissipation boss plate is provided with an avoidance hole, the heat dissipation boss plate is inserted into the avoidance hole and comes into contact with the element to be heat dissipated.

54. The electric control box according to claim 53, wherein the heat dissipation boss plate has a drainage surface configured to discharge water that flows to the drainage surface out of the heat dissipation boss plate.

55. The electric control box according to claim 54, wherein a middle of the drainage surface protrudes relative to both ends of the drainage surface.

56. The electric control box according to claim 55, wherein the drainage surface is a curved surface or a V-shaped surface.

57. The electric control box according to any one of claims 54 to 56, wherein the heat dissipation boss plate is an elongated block, and an end face on a short side of the elongated block forms the drainage surface.

58. The electric control box according to claim 57, wherein both sides of the heat dissipation boss plate are provided with a discharge groove respectively, and two discharge grooves are configured to discharge water flowing down the drainage surface from an area of the heat dissipation plate corresponding the avoidance hole.

59. The electric control box according to claim 58, wherein one of two opposite groove surfaces of the discharge groove is a side surface on a long side of the elongated block, and the side surface is connected to an end of the drainage surface; and the other one of the two opposite groove surfaces of the discharge groove is a side surface of the avoidance hole.

60. The electric control box according to claim 58, wherein the side of the heat dissipation plate facing the installation plate is provided with a limit boss plate which is inserted into the avoidance hole, and an outer circumferential side of the limit boss plate contacts an inner circumferential side of the avoidance hole; and the heat dissipation boss plate and the discharge groove are both arranged on the limit boss plate.

61. The electric control box according to claim 60, wherein the limit boss plate is provided with at least two heat dissipation boss plates; the at least two heat dissipation boss plates are arranged to be spaced apart along a direction perpendicular to an extension direction of the discharge groove; two adjacent heat dissipation boss plates are provided with a block therebetween, and the discharge groove is formed between the block and an adjacent heat dissipation boss plate.

62. The electric control box according to claim 61, wherein a top surface of the block is lower than a top surface of the lowest one of the at least two heat dissipation boss plates, or the top surface of the block is flush with the top surface of the lowest one of the at least two heat dissipation boss plates.

63. The electric control box according to claim 60, wherein both ends of the discharge groove extend to an edge of the limit boss plate.

64. The electric control box according to claim 63, wherein a bottom of the discharge groove is higher than a plane in which a bottom end of the discharge boss plate is arranged, and lower than a top surface of the heat dissipation boss plate.

65. The electric control box according to any one of claims 53 to 56, wherein an edge of the heat dissipation plate is provided with a positioning notch locating an installation position of the heat dissipation plate.

66. The electric control box according to any one of claims 53 to 56, wherein the electric control box is a sealed electric control box, and the heat dissipation plate and the installation plate are both arranged inside the electric control box.

67. An air conditioner, comprising a cabinet body and the electric control box according to any one of claims 53 to 66, wherein the electric control box is mounted on the cabinet body.
